# EUROPEAN PATENT SPECIFICATION

(11) **EP 2 491 585 B1**
(45) Date of publication and mention of the grant of the patent: **22.01.2020**
(21) Application number: 10824778.4
(22) Date of filing: 27.09.2010
(51) Int. Cl.: H01L 21/8238, H01L 21/822, H01L 29/786, H01L 27/06, H01L 27/12, H01L 21/84

(54) **SEMICONDUCTOR DEVICE**
HALBLEITERBAUELEMENT
DISPOSITIF SEMI-CONDUCTEUR

(30) Priority: 21.10.2009 JP 2009242689
(43) Date of publication of application: 29.08.2012
(73) Proprietor: Semiconductor Energy Laboratory Co. Ltd., Atsugi-shi, Kanagawa 243-0036 (JP)
(72) Inventor: YAMAZAKI, Shunpei, Atsugi-shi Kanagawa 243-0036 (JP); KOYAMA, Jun, Kanagawa-ken 243-0036 (JP); IMAI, Keitaro, Kanagawa-ken 232-0007 (JP)
(74) Representative: Grünecker Patent- und Rechtsanwälte PartG mbB
(86) International application number: PCT/JP2010/067294
(87) International publication number: WO 2011/048929

(56) References cited:
- WO-A1-2009/110623
- JP-A- 10 093 100
- JP-A- 11 233 789
- JP-A- H11 233 789
- JP-A- 2007 103 918
- JP-A- 2009 021 446
- JP-A- 2009 135 350
- US-A1- 2006 237 857
- US-A1- 2007 072 439
- US-A1- 2008 093 595
- US-A1- 2009 002 590
- US-A1- 2009 078 970
- US-A1- 2009 155 940
- US-A1- 2010 148 171
- KIM MINKYU ET AL: "High mobility bottom gate InGaZnO thin film transistors with SiOx etch stopper", APPLIED PHYSICS LETTERS, AMERICAN INSTITUTE OF PHYSICS, US, vol. 90, no. 21, 24 May 2007 (2007-05-24), pages 212114-212114, XP012094953, ISSN: 0003-6951, DOI: 10.1063/1.2742790
- MINKYU KIM ET AL.: 'High mobility bottom gate InGaZnO thin film transistors with SiOx etch stopper' APPLIED PHYSICS LETTERS vol. 90, 24 May 2007, pages 212114-1 - 212114-4, XP012094953

## Description

### TECHNICAL FIELD

The technical field of the present invention relates to a semiconductor device. Note that here, semiconductor devices refer to general elements and devices which function utilizing semiconductor characteristics.

### BACKGROUND ART

There are a wide variety of metal oxides, and metal oxides have various applications. Indium oxide is a well-known material and has been used for transparent electrodes required in liquid crystal display devices or the like.

Some metal oxides have semiconductor characteristics. Examples of metal oxides having semiconductor characteristics are tungsten oxide, tin oxide, indium oxide, zinc oxide, and the like. Thin film transistors having channel formation regions made of any of such metal oxides have already been described (e.g. see Patent Documents 1 to 4 and Non-Patent Document 1 etc.).

Incidentally, not only single-component oxides but also multi-component oxides are known as metal oxides. For example, homologous compounds InGaO₃(ZnO)*ₘ* (*m* is a natural number) are known multi-component oxides containing In, Ga and Zn (e.g. see Non-Patent Documents 2 to 4 and the like).

An oxide semiconductor including such an In-Ga-Zn-based oxide is also known to be applicable to the channel forming layer of a thin film transistor (e.g. see Patent Document 5, Non-Patent Documents 5 and 6, and the like).

Patent Document 6 discloses a high-performance highly integrated device in which bulk type FETs (field effect transistors) formed in a single crystalline silicon wafer and TFTs (thin film transistors) formed in a crystallised silicon film are three-dimensionally integrated. In a CMOS type SRAM structure according to an example, the TFTs are bottom-gate type TFTs.

Patent document 7 discloses an SRAM with PFET devices comprising a polysilicon film on tungsten gates, stacked on NFET devices in a silicon substrate.

### [Reference]

### [Patent Documents]

[Patent Document 1] Japanese Published Patent Application No. S60-198861
[Patent Document 2] Japanese Published Patent Application No. H8-264794
[Patent Document 3] Japanese Translation of PCT International Application H11-505377
[Patent Document 4] Japanese Published Patent Application No. 2000-150900
[Patent Document 5] Japanese Published Patent Application No. 2004-103957
[Patent Document 6] Japanese Published Patent Application No. H11-233789
[Patent Document 7] US Patent No. 5,112,765

[Non-Patent Document 1] M. W. Prins, K. O. Grosse-Holz, G. Muller, J. F. M. Cillessen, J. B. Giesbers, R. P. Weening, and R. M. Wolf, "A ferroelectric transparent thin-film transistor", Appl. Phys. Lett., 17 June 1996, Vol. 68, p. 3650-3652
[Non-Patent Document 2] M. Nakamura, N. Kimizuka, and T. Mohri, "The Phase Relations in the In2O3-Ga2ZnO4-ZnO System at 1350 °C", J. Solid State Chem., 1991, Vol. 93, p. 298-315
[Non-Patent Document 3] Kimizuka, M. Isobe, and M. Nakamura, "Syntheses and Single-Crystal Data of Homologous Compounds, In2O3(ZnO)m (m = 3, 4, and 5), InGaO3(ZnO)3, and Ga2O3(ZnO)m (m = 7, 8, 9, and 16) in the In2O3-ZnGa2O4-ZnO System", J. Solid State Chem., 1995, Vol. 116, p. 170-178
[Non-Patent Document 4] M. Nakamura, N. Kimizuka, T. Mohri, and M. Isobe, "Syntheses and crystal structures of new homologous compounds, indium iron zinc oxides (InFeO3(ZnO)m) (m:natural number) and related compounds", KOTAI BUTSURI (SOLID STATE PHYSICS), 1993, Vol. 28, No. 5, p. 317-327
[Non-Patent Document 5] K. Nomura, H. Ohta, K. Ueda, T. Kamiya, M. Hirano, and H. Hosono, "Thin-film transistor fabricated in single-crystalline transparent oxide semiconductor", SCIENCE, 2003, Vol. 300, p. 1269-1272
[Non-Patent Document 6] K. Nomura, H. Ohta, A. Takagi, T. Kamiya, M. Hirano, and H. Hosono, "Room-temperature fabrication of transparent flexible thin-film transistors using amorphous oxide semiconductors", NATURE, 2004, Vol. 432 p. 488-492

### DISCLOSURE OF INVENTION

Field-effect transistors, which are typical examples of semiconductor devices, are generally formed using a material such as silicon. However, semiconductor devices using silicon or the like do not have adequate switching characteristics; e.g. a problem is that a semiconductor device is damaged by a significantly high flow-through current in the case of the fabrication of a CMOS inverter circuit and that the power consumption is increased by a significantly high flow-through current.

Moreover, the off-state current (also referred to as the leakage current) of semiconductor devices using silicon or the like is not as low as substantially zero. Therefore, a flow of slight current occurs without respect to the intended behavior of the semiconductor device, and thus it has been difficult to ensure an adequate period for charge retention in the case of the fabrication of a charge-retention semiconductor device such as memory or a liquid crystal display. A further problem is that the power consumption is increased by the off-state current.

In view of this, an object of one embodiment of the present invention is to provide a semiconductor device with a new structure which solves the above problems.

The present invention is directed to a semiconductor device as defined in claim 1. Preferred embodiments are defined in the dependent claims.

Note that in this specification, the terms like "above" and "below" do not necessarily mean "directly above" and "directly below", respectively, in the description of a physical relationship between components. For example, the expression "a first gate electrode over a gate insulating layer" can correspond to a situation where there is an additional component between the gate insulating layer and the first gate electrode. The terms "above" and "below" are just used for convenience of explanations and they can be interchanged unless otherwise specified.

In this specification, the term "electrode" or "wiring" does not limit the function of components. For example, an "electrode" can be used as part of a "wiring", and the "wiring" can be used as part of the "electrode". In addition, the term "electrode" or "wiring" can also mean a combination of a plurality of "electrodes" and "wirings", for example.

In general, the term "SOI substrate" means a substrate having a silicon semiconductor layer over an insulating surface. In this specification, the term "SOI substrate" also means a substrate having a semiconductor layer using a material other than silicon over an insulating surface. In other words, a semiconductor layer included in the "SOI substrate" is not limited to a silicon semiconductor layer. In addition, a substrate in an "SOI substrate" is not limited to a semiconductor substrate such as a silicon wafer, and may be a non-semiconductor substrate such as a glass substrate, a quartz substrate, a sapphire substrate, and a metal substrate. In other words, "SOI substrates" also include a conductive substrate having an insulating surface or a substrate having a layer of a semiconductor material over an insulating substrate. In addition, in this specification and the like, a "semiconductor substrate" means a substrate of only a semiconductor material and also a general substrate of a material including a semiconductor material. In other words, in this specification, "SOI substrates" are also included in the broad category of semiconductor substrates.

The present invention as defined in claim 1 provides a semiconductor device including a transistor using silicon in its lower part, and a transistor using an oxide semiconductor in its upper part.

A combination of a transistor using silicon and a transistor using an oxide semiconductor allows for the production of a semiconductor device requiring electric characteristics different from those of transistors using an oxide semiconductor (e.g. difference in carriers characteristics, which have an effect on the behavior of the element).

Further, a transistor using an oxide semiconductor has good switching characteristics, so that an excellent semiconductor device can be made utilizing these characteristics. Further, a transistor using an oxide semiconductor has extremely low off-state current, and the use of this transistor hence can reduce the power consumption of the semiconductor device.

### BRIEF DESCRIPTION OF DRAWINGS

FIG. 1A is a cross-sectional view illustrating a semiconductor device and FIG. 1B is a plane view thereof.
FIG. 2 is a circuit diagram illustrating a semiconductor device.
FIG. 3A is a cross-sectional view illustrating a semiconductor device and FIG. 3B is a plane view thereof.
FIGS. 4A to 4H are cross-sectional views illustrating the manufacturing method of a semiconductor device.
FIGS. 5A to 5G are cross-sectional views illustrating a manufacturing method of a semiconductor device.
FIGS. 6A to 6D are cross-sectional views illustrating a manufacturing method of a semiconductor device.
FIG. 7A is a cross-sectional view illustrating a semiconductor device and FIG. 7B is a plane view thereof.
FIG. 8 is a circuit diagram illustrating a semiconductor device.
FIG. 9A is a cross-sectional view illustrating a semiconductor device and FIG. 9B is a plane view thereof.
FIG. 10 is a circuit diagram illustrating a semiconductor device.
FIGS. 11A to 11F are diagrams for explaining electronic appliances using a semiconductor device.

### BEST MODE FOR CARRYING OUT THE INVENTION

Hereinafter, an "embodiment" not forming part of the claimed invention and embodiments of the claimed invention will be described with reference to the drawings. Specifically, embodiment 1, despite of the term "embodiment", does not form part of the claimed invention. Embodiments 2 and 3 are embodiments of the claimed invention. Embodiment 4 is directed to electronic appliances equipped with the semiconductor device according to embodiments 1, 2 or 3. Depending on the semiconductor device comprised therein, the electronic appliances are therefore part of the claimed invention (embodiments 2 or 3) or not (embodiment 1). Note that the present invention is not limited to the following description, and it will be easily understood by those skilled in the art that various changes and modifications can be made without departing from the scope of the present invention. Thus, the present invention should not be interpreted as being limited to the following description of the embodiments.

Note that in some cases, the position, size, range of each component are not actual ones in the drawings and the like in order to facilitate understanding.

Note that in this specification, ordinal numbers such as "first", "second", and "third" are used in order to avoid confusion among components, and the terms do not limit the components numerically.

### (Embodiment 1)

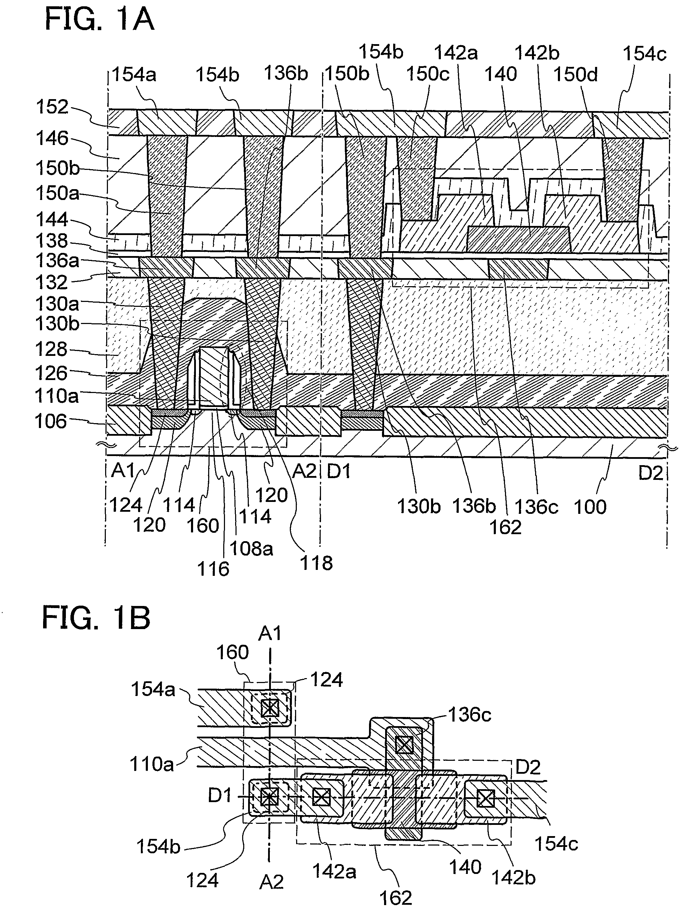

In this embodiment not forming part of the claimed invention, the structure and the manufacturing method of a semiconductor device will be described with reference to FIGS. 1A and 1B, FIG. 2, FIGS. 3A and 3B, FIGS. 4A to 4H, FIGS. 5A to 5G, and FIGS. 6A to 6D.

### <The structure of the semiconductor device>

FIG. 1A shows a cross-sectional view of the semiconductor device according to this embodiment. FIG. 1B shows a plane view of the semiconductor device according to this embodiment. Here, FIG. 1A corresponds to section A1-A2 and D1-D2 shown in FIG. 1B. The semiconductor device shown in FIGS. 1A and 1B includes a p-type transistor 160 in its lower part and an n-type transistor 162 using an oxide semiconductor in its upper part.

The p-type transistor 160 includes a channel formation region 116 in a substrate 100 containing a semiconductor material; impurity regions 114 and heavily doped regions 120, a combination of the impurity regions 114 and the heavily doped regions 120 can simply be referred to as impurity regions, impurity regions between which is interposed the channel formation region 116; a gate insulating layer 108a over the channel formation region 116; a gate electrode 110a over the gate insulating layer 108a; a source or drain electrode 130a electrically connected to a first impurity region 114 on one side of the channel formation region 116; and a source or drain electrode 130b electrically connected to a second impurity region 114 on another side of the channel formation region 116.

Here, side wall insulating layers 118 are formed on the sides of the gate electrode 110a. Moreover, at least parts of the side wall insulating layers 118 are comprised between the heavily doped regions 120 formed in regions of the substrate 100, when seen from above, and metal compound regions 124 are present over the heavily doped regions 120. Further, an element insulation insulating layer 106 is formed over the substrate 100 so as to surround the p-type transistor 160, and an interlayer insulating layer 126 and an interlayer insulating layer 128 are formed so as to cover the p-type transistor 160. The source or drain electrode 130a is electrically connected to a first metal compound region 124 on the one side of the channel formation region 116, and the source or drain electrode 130b is electrically connected to a second metal compound region 124 on the other side of the channel formation region 116 through openings in the interlayer insulating layer 126 and the interlayer insulating layer 128. In other words, the source or drain electrode 130a is electrically connected to a first heavily doped region 120 and to the first impurity region 114 which are on the one side of the channel formation region 116 through the first metal compound region 124 on the one side of the channel formation region 116, and the source or drain electrode 130b is electrically connected to a second heavily doped region 120 and to the second impurity region 114 which are on the other side of the channel formation region 116 through the second metal compound region 124 on the other side the channel formation region 116.

The n-type transistor 162 includes a gate electrode 136c over the interlayer insulating layer 128; a gate insulating layer 138 over the gate electrode 136c; an oxide semiconductor layer 140 over the gate insulating layer 138; and a source or drain electrode 142a and a source or drain electrode 142b which are over the oxide semiconductor layer 140 and electrically connected to the oxide semiconductor layer 140.

Here, the gate electrode 136c of the n-type transistor 162 is formed so as to be embedded in an insulating layer 132 which is over the interlayer insulating layer 128. Further, as in the case of the gate electrode 136c, an electrode 136a and an electrode 136b are formed so as to be on the source and drain electrodes 130a and 130b of the p-type transistor 160.

A protective insulating layer 144 is formed over the n-type transistor 162 so as to be in contact with part of the oxide semiconductor layer 140. An interlayer insulating layer 146 is formed over the protective insulating layer 144. Here, the protective insulating layer 144 and the interlayer insulating layer 146 are provided with openings reaching the source or drain electrode 142a and the source or drain electrode 142b. An electrode 150c and an electrode 150d are each in contact with one of the source or drain electrode 142a and the source or drain electrode 142b through the openings. As in the case of the electrode 150c and the electrode 150d, an electrode 150a and an electrode 150b are formed in contact with the electrode 136a and the electrode 136b, respectively, through openings in the gate insulating layer 138, the protective insulating layer 144, and the interlayer insulating layer 146.

The oxide semiconductor layer 140 is preferably of high purity, produced by adequate removal of an impurity such as hydrogen. Specifically, the hydrogen concentration of the oxide semiconductor layer 140 is 5×10¹⁹ atoms/cm³ or less. Preferably, the hydrogen concentration of the oxide semiconductor layer 140 is 5×10¹⁸ atoms/cm³ or less, and more preferably 5×10¹⁷ atoms/cm³ or less. The n-type transistor 162 can have excellent off-state current characteristics by using the oxide semiconductor layer 140 with high purity produced by an adequate reduction in hydrogen concentration. For example, when the drain voltage Vd is +1 or +10 V and the gate voltage Vg ranges from -20 to -5 V, the off-state current is 1×10⁻¹³ A or less. Thus, the off-state current of the n-type transistor 162 is reduced by the use of the oxide semiconductor layer 140 with high purity produced by an adequate reduction in hydrogen concentration, thereby leading to a semiconductor device having excellent characteristics. Note that the above hydrogen concentration of the oxide semiconductor layer was measured by SIMS (secondary ion mass spectroscopy).

An insulating layer 152 is formed over the interlayer insulating layer 146. An electrode 154a, an electrode 154b, and an electrode 154c are formed so as to be embedded in the insulating layer 152. Here, the electrode 154a is in contact with the electrode 150a, the electrode 154b is in contact with the electrodes 150b and 150c, and the electrode 154c is in contact with the electrode 150d.

In other words, in the semiconductor device shown in FIGS. 1A and 1B, the source or drain electrode 130b of the p-type transistor 160 is electrically connected to the source or drain electrode 142a of the n-type transistor 162 through the electrode 136b, the electrode 150b, the electrode 154b, and the electrode 150c.

Moreover, the gate electrode 110a of the p-type transistor 160 is electrically connected to the gate electrode 136c of the n-type transistor 162 through the electrodes built in the interlayer insulating layer 126 and the interlayer insulating layer 128.

Note that the source or drain electrode 130a of the p-type transistor 160 is electrically connected, through the electrode 154a, the electrode 150a, and the electrode 136a, to the power supply line for supplying a first potential. The source or drain electrode 142b of the n-type transistor 162 is electrically connected, through the electrode 154c and the electrode 150d, to the power supply line for supplying a second potential.

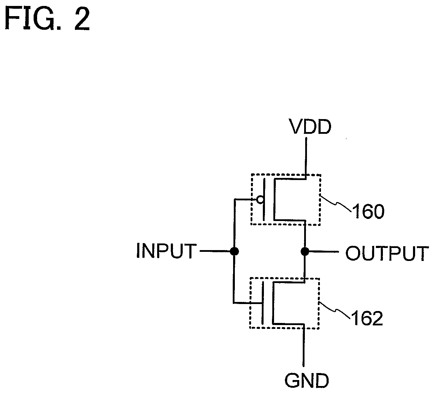

FIG. 2 shows an equivalent circuit of a CMOS inverter circuit in which the p-type transistor 160 is connected to the n-type transistor 162 in a complementary manner. FIG. 2 shows an example of the semiconductor device illustrated in FIGS. 1A and 1B in which the positive potential VDD is applied to the electrode 154a and the ground potential GND is applied to the electrode 154c. Note that the ground potential GND can be also referred to as the negative potential VDL.

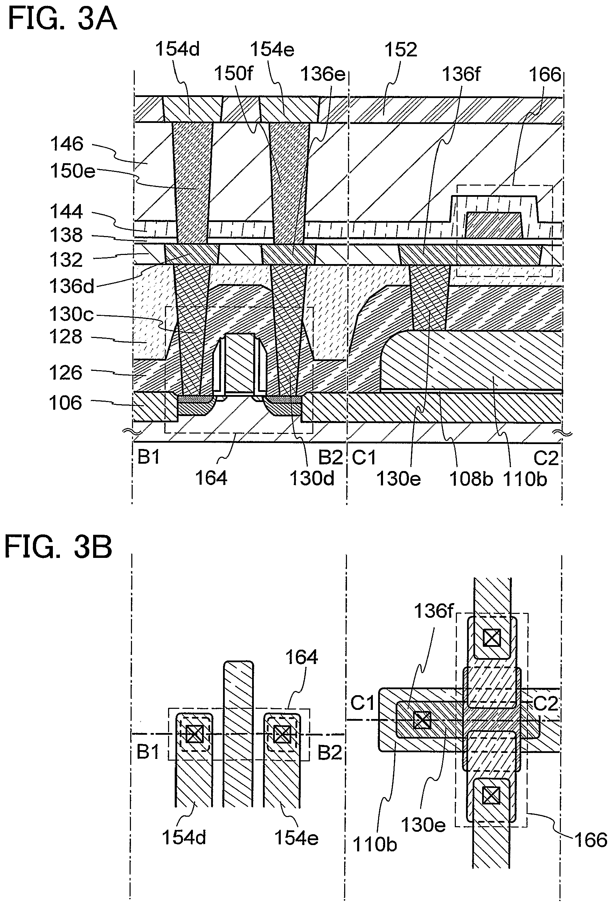

Next, a semiconductor device in which either an n-type transistor or a p-type transistor is used alone with the same substrate as that of the above semiconductor device will be described with reference to FIGS. 3A and 3B. FIG. 3A shows a cross-sectional view of a p-type transistor 164 in the lower part and an n-type transistor 166 using an oxide semiconductor in the upper part. FIG. 3B shows a plane view of the same. Note that FIG. 3A is a cross-sectional view showing section B1-B2 and section C1-C2 in FIG. 3B. In FIGS. 3A and 3B, the same components as those in FIGS. 1A and 1B are denoted by the same reference numerals as those of FIGS. 1A and 1B.

First, the structure and electrical connections of the p-type transistor 164 will be described. A source or drain electrode 130c and source or drain electrode 130d of the p-type transistor 164 are electrically connected to an electrode 136d and an electrode 136e, respectively, which are formed so as to embed themselves in the insulating layer 132. The electrode 136d and the electrode 136e are electrically connected to an electrode 150e and an electrode 150f, respectively, which are formed so as to be embedded in the gate insulating layer 138, the protective insulating layer 144, and the interlayer insulating layer 146. The electrode 150e and the electrode 150f are respectively electrically connected to the electrode 154d and the electrode 154e which are formed so as to be embedded in the insulating layer 152. Thus, the source or drain electrode 130c of the p-type transistor 164 is electrically connected, through the electrode 136d, the electrode 150e, and the electrode 154d, to a power supply line which supplies a first potential, and the source or drain electrode 130d is electrically connected, through the electrode 136e, the electrode 150f, and the electrode 154e, to the power supply line which supplies a second potential. Therefore, the p-type transistor 164 can be used alone.

Next, the structure and electrical connections of the n-type transistor 166 will be described. A gate insulating layer 108b is formed over the element insulation insulating layer 106. A gate wiring 110b is provided over the gate insulating layer 108b. The gate wiring 110b is electrically connected to an electrode 130e formed so as to be embedded in the interlayer insulating layer 126 and the interlayer insulating layer 128. The electrode 130e is electrically connected to a gate electrode 136f formed so as to be embedded in the insulating layer 132. Thus, the gate electrode 136f of the n-type transistor 166 is electrically connected to the gate wiring 110b through the electrode 130e, so that the n-type transistor 166 can be used alone.

### <Manufacturing Method of the Semiconductor Device>

Next, an example of a manufacturing method of the above semiconductor device will be described. First, a manufacturing method of the p-type transistor in the lower part and then, a manufacturing method of the n-type transistor in the upper part will be described.

### <Manufacturing Method of the P-type Transistor>

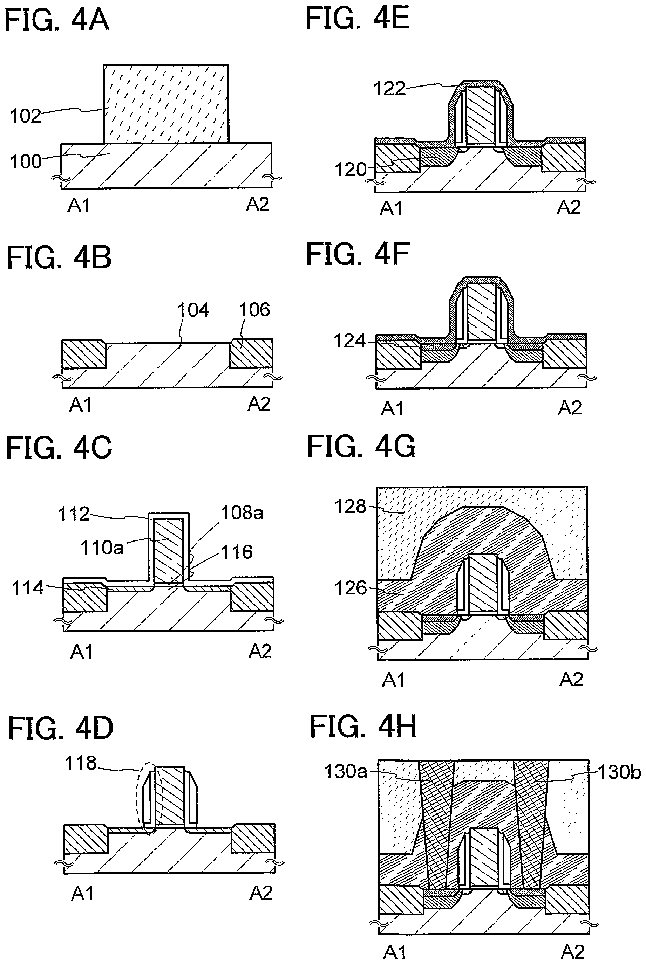

First, a substrate 100 which contains a semiconductor material is prepared (see FIG. 4A). A single crystal semiconductor substrate of silicon, carbon silicon, or the like; a microcrystalline semiconductor substrate; a compound semiconductor substrate of silicon germanium or the like; an SOI substrate, or the like can be used as the substrate 100 which contains a semiconductor material. Here, an example of the case where a single crystal silicon substrate is used as the substrate 100 which contains a semiconductor material is described. Note that in general, the term "SOI substrate" means a semiconductor substrate having a silicon semiconductor layer over its insulating surface. In this specification and the like, the term "SOI substrate" also means a substrate having a semiconductor layer using a material other than silicon over its insulating surface. In other words, a semiconductor layer included in the "SOI substrate" is not limited to a silicon semiconductor layer. Examples of the SOI substrate include an insulating substrate such as glass having a semiconductor layer over its surface, with an insulating layer between the semiconductor layer and the insulating substrate.

A protective layer 102 that serves as a mask for forming an insulating element insulating layer is formed over the substrate 100 (see FIG. 4A). An insulating layer of silicon oxide, silicon nitride, silicon nitride oxide, or the like, for example, can be used as the protective layer 102. Note that before and after this step, an impurity element giving n-type conductivity or an impurity element giving p-type conductivity can be added to the substrate 100 in order to control the threshold voltage of the transistor. In the case where silicon is used as the semiconductor, phosphorus, arsenic, or the like can be used as an impurity giving n-type conductivity. On the other hand, boron, aluminum, gallium, or the like can be used as an impurity giving p-type conductivity.

Next, a region of the substrate 100 which is not covered with the protective layer 102 (exposed region) is etched using the protective layer 102 as a mask. Thus, an isolated semiconductor region 104 is formed (see FIG. 4B). Although dry etching is preferably employed as the etching, wet etching can also be employed as the etching. An etching gas and an etchant can be selected as appropriate in accordance with a material of layers to be etched.

Next, an insulating layer is formed so as to cover the semiconductor region 104 and a region of the insulating layer which overlaps with the semiconductor region 104 is selectively etched, forming element insulation insulating layer 106 (see FIG. 4B). The insulating layer is formed using silicon oxide, silicon nitride, silicon nitride oxide, or the like. Methods for removing the insulating layer over the semiconductor region 104 include etching, polishing such as CMP, and the like, and any of these are applicable. Note that after the semiconductor region 104 is formed or after the element insulation insulating layer 106 are formed, the protective layer 102 is removed.

Next, an insulating layer is formed over the semiconductor region 104, and a layer containing a conductive material is formed over the insulating layer.

It is recommended that the insulating layer, which is to be a gate insulating layer, has a single-layer structure or a layered structure of films containing silicon oxide, silicon nitride oxide, silicon nitride, hafnium oxide, aluminum oxide, tantalum oxide, or the like obtained by CVD, sputtering, or the like. Alternatively, the insulating layer can be formed by oxidizing or nitriding a surface of the semiconductor region 104 by high-density plasma treatment or thermal oxidation treatment. The high-density plasma treatment can be performed using a rare gas such as He, Ar, Kr, or Xe and a mixed gas of oxygen, nitrogen oxide, ammonia, nitrogen, hydrogen, or the like, for example. There is no particular limitation on the thickness of the insulating layer; the thickness of the insulating layer can range from 1 to 100 nm, for example.

The layer containing a conductive material can be formed using a metal material such as aluminum, copper, titanium, tantalum, and tungsten. Alternatively, the layer containing a conductive material can be formed using a semiconductor material such as polycrystalline silicon containing a conductive material. There is no particular limitation on the method for forming the layer containing a conductive material; a variety of deposition methods, such as vapor deposition, CVD, sputtering, and spin coating are applicable. Note that in this embodiment, an example of a case where the layer containing a conductive material is formed using a metal material is described.

After that, the insulating layer and the layer containing a conductive material are selectively etched, thereby forming a gate insulating layer 108a and a gate electrode 110a (see FIG. 4C). Note that the gate wiring 110b shown in FIGS. 3A and 3B can be formed in the same formation step here.

Next, an insulating layer 112 which covers the gate electrode 110a is formed (see FIG. 4C). Then, boron (B), aluminum (Al), or the like is added to the semiconductor region 104, forming impurity regions 114 with a shallow junction depth (see FIG. 4C). Note that by forming the impurity regions 114, a portion of the semiconductor region 104 which is below the gate insulating layer 108a becomes a channel formation region 116 (see FIG. 4C). Here, the concentration of the added impurity can be set as appropriate; the concentration is preferably raised in accordance with the degree of miniaturization of the semiconductor element. Here, a process in which the impurity regions 114 are formed after the insulating layer 112 is formed is employed; alternatively, a process in which the insulating layer 112 is formed after the impurity regions 114 are formed can be employed.

Next, side wall insulating layers 118 are formed (see FIG. 4D). The side wall insulating layers 118 can be formed in a self-aligned manner by forming an insulating layer covering the insulating layer 112 and then performing highly anisotropic etching on the insulating layer. Here, the insulating layer 112 is partly etched, so that a top surface of the gate electrode 110a and a top surface of the impurity regions 114 are exposed.

Next, an insulating layer is formed so as to cover the gate electrode 110a, the impurity regions 114, the side wall insulating layers 118, and the like. Then, boron (B), aluminum (Al), or the like is added to a region where the insulating layer is in contact with the impurity regions 114, thereby forming heavily doped regions 120 (see FIG. 4E). After that, the insulating layer is removed, and a metal layer 122 is formed so as to cover the gate electrode 110a, the side wall insulating layers 118, the heavily doped regions 120, and the like (see FIG. 4E). The metal layer 122 can be formed by a variety of methods, such as vapor deposition, sputtering, and spin coating. It is preferable that the metal layer 122 be formed using a metal material which, by reacting with a semiconductor material included in the semiconductor region 104, may become a metal compound having low resistance. Examples of such metal materials include titanium, tantalum, tungsten, nickel, cobalt, and platinum.

Next, heat treatment is performed, so that the metal layer 122 reacts with the semiconductor material. Thus, metal compound regions 124 which are in contact with the heavily doped regions 120 are formed (see FIG. 4F). Note that when the polycrystalline silicon or the like is used for the gate electrode 110a, a metal compound region is also formed in a portion where the gate electrode 110a is in contact with the metal layer 122.

For example, irradiation with a flash lamp can be used for the above heat treatment. Naturally, another heat treatment is acceptable; a method which realizes brief periods of heat treatment is preferably used in order to improve the controllability of chemical reaction relating to the formation of the metal compound. Note that the metal compound regions have adequately high conductivity because they are formed by the reaction of the metal material and the semiconductor material. The metal compound regions can adequately reduce electric resistance and improve element characteristics. Note that the metal layer 122 is removed after the metal compound regions 124 are formed.

Next, an interlayer insulating layer 126 and an interlayer insulating layer 128 are formed so as to cover the elements formed in the above steps (see FIG. 4G). The interlayer insulating layers 126 and 128 can be formed using a material including an inorganic insulating material, such as silicon oxide, silicon nitride oxide, silicon nitride, hafnium oxide, aluminum oxide, and tantalum oxide. Alternatively, an organic insulating material such as polyimide and acrylic can be used. Although the interlayer insulating layer 126 and the interlayer insulating layer 128 form a two-layer structure here, the structure of the interlayer insulating layers is not limited to this. After the interlayer insulating layer 128 is formed, a surface thereof is preferably flattened by CMP, etching, or the like.

In a next step, openings which reach the metal compound regions 124 are formed in the interlayer insulating layers, and a source or drain electrode 130a and a source or drain electrode 130b (each of which is also referred to as a source wiring or drain wiring) are formed in the openings (see FIG. 4H). For example, the source or drain electrode 130a and the source or drain electrode 130b are formed in the following manner: a conductive layer is formed in a region including the openings by PVD, CVD, or the like, and then, the conductive layer is partly removed by etching or CMP.

Note that in the case where the source or drain electrode 130a and the source or drain electrode 130b are formed by removing part of the conductive layer, it is preferable that a surface thereof be processed to be flat. For example, in the case of forming a tungsten film embedded in openings after a thin titanium film or a thin titanium nitride film has been formed in a region including the openings, CMP performed afterwards can remove unnecessary part of the tungsten film, titanium film, titanium nitride film, and the like, and improve the flatness of the surface. Adequate electrodes, wirings, insulating layers, semiconductor layers, or the like can be formed in the later steps by such an improvement in the flatness of a surface of the source or drain electrode 130a and source or drain electrode 130b.

Although only the source or drain electrode 130a and the source or drain electrode 130b in contact with the metal compound regions 124 are shown here, a wiring which is to be in contact with the gate electrode 110a or the like can be formed in the same formation step. Further, at that time, the connection electrode 130e which is in contact with the gate wiring 110b shown in FIGS. 3A and 3B can be formed. There is no particular limitation on the material for the source or drain electrode 130a and the source or drain electrode 130b; a variety of conductive materials are applicable. For example, a conductive material such as molybdenum, titanium, chromium, tantalum, tungsten, aluminum, copper, neodymium, and scandium is applicable.

The above process allows a p-type transistor using the substrate 100 containing a semiconductor material to be formed. After the above process, an additional wiring or the like can be formed. Multilayer interconnection structure using a layered structure of an interlayer insulating layer and a conductive layer provides a highly integrated semiconductor device.

### <Manufacturing Method of the N-type Transistor>

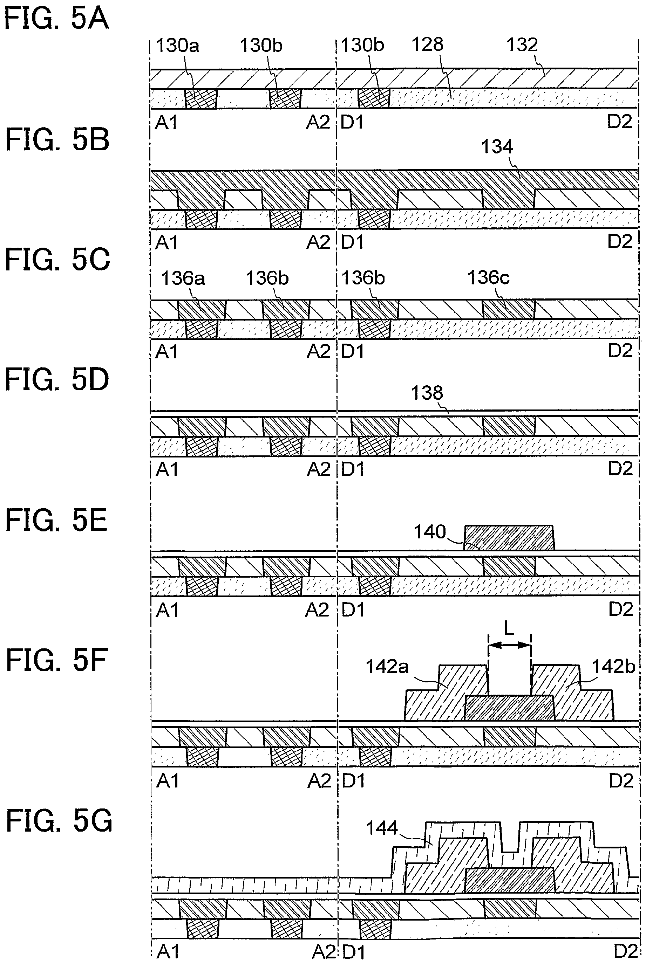

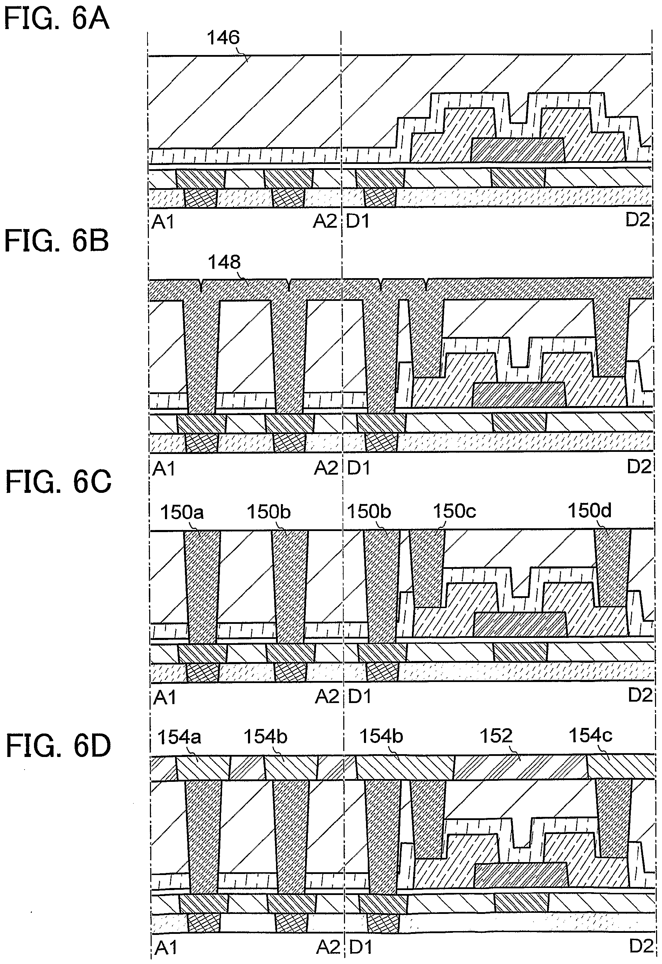

Next, a process of forming the n-type transistor over the interlayer insulating layer 128 will be described with reference to FIGS. 5A to 5G and FIGS. 6A to 6D. FIGS. 5A to 5G and FIGS. 6A to 6D illustrate the manufacturing method of the n-type transistor and show a cross-sectional views along section A1-A2 and section D1-D2 in FIGS. 1A and 1B. Note that the p-type transistor which is below the n-type transistor is omitted in FIGS. 5A to 5G and FIGS. 6A to 6D.

First, an insulating layer 132 is formed over the interlayer insulating layer 128, the source or drain electrode 130a, and the source or drain electrode 130b (see FIG. 5A). The insulating layer 132 can be formed by PVD, CVD, or the like. The insulating layer 132 can be formed using a material containing an inorganic insulating material such as silicon oxide, silicon nitride oxide, silicon nitride, hafnium oxide, aluminum oxide, and tantalum oxide.

Next, an opening reaching the source or drain electrode 130a, and an opening reaching the source or drain electrode 130b are formed in the insulating layer 132. At that time, an additional opening is formed in a region where a gate electrode will be formed. Then, a conductive layer 134 is formed so as to fill the openings (see FIG. 5B). The openings can be formed by etching or the like using a mask. The mask can be made by exposures using a photomask, for example. Either wet etching or dry etching can be used as the etching; in view of the fine patterning, dry etching is preferable. The conductive layer 134 can be formed by a deposition method such as PVD and CVD. Examples of the material for the conductive layer 134 include a conductive material such as molybdenum, titanium, chromium, tantalum, tungsten, aluminum, copper, neodymium, and scandium; and an alloy and compound (e.g. nitride) of any of these materials.

Specifically, the method can employ a thin titanium film formed by PVD in a region including openings, a thin titanium nitride film formed by CVD, and a tungsten film formed so as to fill the openings. Here, the titanium film formed by PVD has a function of reducing an oxide film at an interface with a lower electrode (here, the source or drain electrode 130a or the source or drain electrode 130b), and thus reducing contact resistance to the lower electrode. The titanium nitride film to be formed afterwards has a barrier function of blocking diffusion of the conductive material.

After the conductive layer 134 is formed, part of the conductive layer 134 is removed by etching or CMP, and the insulating layer 132 is thus exposed, thereby forming an electrode 136a, an electrode 136b, and a gate electrode 136c (see FIG. 5C). Note that when the electrode 136a, the electrode 136b, the gate electrode 136c are formed by removing part of the conductive layer 134, it is preferable that a surface of the insulating layer 132, the electrode 136a, the electrode 136b, and the gate electrode 136c be processed to be flat. Adequate electrodes, wirings, insulating layers, semiconductor layers, or the like can be formed in the later steps by such an improvement in the flatness of a surface of the insulating layer 132, the electrode 136a, the electrode 136b, and the gate electrode 136c.

Next, a gate insulating layer 138 is formed so as to cover the insulating layer 132, the electrode 136a, the electrode 136b, and the gate electrode 136c (see FIG. 5D). The gate insulating layer 138 can be formed by CVD, sputtering, or the like. The gate insulating layer 138 preferably contains silicon oxide, silicon nitride, silicon oxynitride, silicon nitride oxide, aluminum oxide, or the like. Note that the gate insulating layer 138 has either a single-layer structure or a layered structure. For example, the gate insulating layer 138 of silicon oxynitride can be formed by plasma CVD using silane (SiH₄), oxygen, and nitrogen as a source gas. There is no particular limitation on the thickness of the gate insulating layer 138; the thickness can range from 20 to 500 nm, for example. When the layered structure is employed, the gate insulating layer 138 preferably has a first gate insulating layer with a thickness ranging from 50 to 200 nm and a second gate insulating layer with a thickness ranging from 5 to 300 nm which is over the first gate insulating layer.

An i-type or substantially i-type oxide semiconductor achieved by the removal of impurities (an oxide semiconductor of high purity) is extremely sensitive to interface state density or interface charge. Therefore, an interface between an oxide semiconductor layer and a gate insulating layer is an important factor in the case where such an oxide semiconductor is used for the oxide semiconductor layer. In other words, the gate insulating layer 138 which is in contact with an oxide semiconductor layer of high purity needs to be of high quality.

For example, high-density plasma CVD using microwaves (2.45 GHz) is preferable in that it produces a compact high-quality gate insulating layer 138 of high withstand voltage. This is because a close contact between an oxide semiconductor layer with high purity and a high-quality gate insulating layer reduces interface state density and produces adequate interface characteristics.

Needless to say, even when an oxide semiconductor layer with high purity is used, another method such as sputtering and plasma CVD is applicable if capable of producing a gate insulating layer of good quality. Alternatively, by heat treatment performed after the deposition of an insulating layer, the insulating layer can be formed such that the quality of a gate insulating layer or interface characteristics between the gate insulating layer and an oxide semiconductor layer is improved. In any cases, a layer is acceptable as long as the layer can be used for a gate insulating layer, can reduces interface state density between the gate insulating layer and the oxide semiconductor layer, and can provide a good interface.

Moreover, when an impurity is contained in an oxide semiconductor, in the bias temperature test (BT test) at 85 °C for 12 hours with electric field strength of 2×10⁶ V/cm, a bond between the impurity and the main component of the oxide semiconductor is cut by a strong electric field (B: bias) and a high temperature (T: temperature), thus generating a dangling bond leading to a shift in the threshold voltage (Vth).

On the other hand, one can provide a transistor which is stable even when subjected to a BT test, by removing impurities in an oxide semiconductor, especially hydrogen or water, and giving good interface characteristics between a gate insulating layer and an oxide semiconductor layer, as described above.

Next, an oxide semiconductor layer is formed over the gate insulating layer 138, and the oxide semiconductor layer is processed by etching using a mask or the like, forming an island-shaped oxide semiconductor layer 140 (see FIG. 5E).

Such an oxide semiconductor layer is preferably an oxide semiconductor layer, especially an amorphous oxide semiconductor layer using one of an In-Ga-Zn-O-based oxide semiconductor, an In-Sn-Zn-O-based oxide semiconductor, an In-Al-Zn-O-based oxide semiconductor, a Sn-Ga-Zn-O-based oxide semiconductor, an Al-Ga-Zn-O-based oxide semiconductor, a Sn-Al-Zn-O-based oxide semiconductor, an In-Zn-O-based oxide semiconductor, a Sn-Zn-O-based oxide semiconductor, an Al-Zn-O-based oxide semiconductor, an In-O-based oxide semiconductor, a Sn-O-based oxide semiconductor, and a Zn-O-based oxide semiconductor. In this embodiment, an amorphous oxide semiconductor layer is formed as the oxide semiconductor layer by sputtering, using an In-Ga-Zn-O-based oxide semiconductor target. The addition of silicon to an amorphous oxide semiconductor layer suppress the crystallization of the layer; therefore, the oxide semiconductor layer can be formed using a target containing SiO₂ at 2 to 10 wt. %.

Such a target for forming the oxide semiconductor layer by sputtering can be a target which is intended for the deposition of an oxide semiconductor and whose main component is zinc oxide, or a target which is intended for the deposition of an oxide semiconductor and which contains In, Ga, and Zn (a composition ratio is In₂O₃: Ga₂O₃: ZnO= 1 : 1 : 1 (molar ratio)). The composition ratio of the target which is intended for the deposition of an oxide semiconductor and which contains In, Ga, and Zn can be In₂O₃ : Ga₂O₃ : ZnO = 1 : 1 : 2 (molar ratio) or In₂O₃ : Ga₂O₃ : ZnO = 1 : 1 : 4 (molar ratio). The filling factor of the target which is intended for the deposition of an oxide semiconductor is 90 to 100 %, and preferably 95 to 99.9 %. A target with a high filling factor which is intended for the deposition of an oxide semiconductor produces a compact oxide semiconductor layer.

The atmosphere for the deposition is preferably a rare gas (typically argon) atmosphere, an oxygen atmosphere, or a mixed atmosphere of a rare gas (typically argon) and oxygen. Specifically, a high-purity gas, in which the concentration of impurities such as hydrogen, water, hydroxyl, and hydride is reduced to approximately several parts per million (preferably several parts per billion), is preferable.

For the deposition of the oxide semiconductor layer, a substrate is set in a chamber at reduced pressure and the substrate temperature is set to be comprised between 100 and 600 °C, and preferably between 200 and 400 °C. Depositing while heating the substrate reduces the concentration of impurities contained in a deposited oxide semiconductor layer and also reduces damage to the layer due to sputtering. Then, moisture remaining in the treatment chamber is removed at the same time as the introduction of a sputtering gas from which hydrogen and moisture are removed into the treatment chamber where a metal oxide is used as a target, thereby forming an oxide semiconductor layer. In order to remove remaining moisture in the treatment chamber, a sorption vacuum pump is preferably used. A cryopump, an ion pump, or a titanium sublimation pump can be used. The evacuation unit can be a turbo pump provided with a cold trap. A hydrogen atom, a compound containing a hydrogen atom, such as water (H₂O), (more preferably also a compound containing a carbon atom), and the like are removed from the deposition chamber when evacuated with a cryopump, thereby reducing the impurity concentration of the oxide semiconductor layer formed in the deposition chamber.

For example, the deposition condition is as follows: the distance between a substrate and a target is 100 mm, the pressure is 0.6 Pa, the direct-current (DC) power is 0.5 kW, and the atmosphere is an oxygen atmosphere (the proportion of oxygen in the oxygen flow rate is 100 %). Note that the use of a pulse direct-current (DC) power source is preferable in that it reduces powder substances (also referred to as particles or dust) which occur at the time of the deposition and in that it makes the film thickness even. The thickness of the oxide semiconductor layer preferably ranges from 2 to 200 nm, and preferably 5 to 30 nm. Note that the appropriate thickness changes depending on the oxide semiconductor material used, and thus the thickness is selected as appropriate depending on the material used.

Note that before the oxide semiconductor layer is formed by sputtering, dust attached to a surface of the gate insulating layer 138 is preferably removed by reverse sputtering where plasma is generated by the introduction of an argon gas. Here the reverse sputtering means a method for improving the quality of a surface by ions striking the surface, while general sputtering is achieved by ions striking on a sputter target. Methods for making ions strike a surface include a method in which high frequency voltage is applied on the surface under an argon atmosphere and plasma is generated in the vicinity of the substrate. Note that a nitrogen atmosphere, helium atmosphere, oxygen atmosphere, or the like can be used instead of an argon atmosphere.

The etching of the oxide semiconductor layer can be either dry etching or wet etching. Naturally, the etching can alternatively be a combination of dry etching and wet etching. Etching conditions (such as etching gas, etchant, etching time, and temperature) are appropriately adjusted in accordance with the material in order for the material to be etched into desired shapes.

For example, a gas containing chlorine (a chlorine-based gas such as chlorine (Cl₂), triboron chloride (BCl₃), tetrasilicon chloride (SiCl₄), or tetracarbon tetrachloride (CCl₄)) can be employed as an etching gas used for the dry etching. Alternatively, a gas containing fluorine (a fluorine-based gas such as carbon tetrafluoride (CF₄), sulfur fluoride (SF₆), nitrogen fluoride (NF₃), or trifluoromethane (CHF₃)); hydrogen bromide (HBr); oxygen (O₂); any of these gases to which a rare gas such as helium (He) or argon (Ar) is added; or the like can be used.

Parallel plate RIE (reactive ion etching) or ICP (inductively coupled plasma) etching can be employed as the dry etching. In order for the films to be etched into desired shapes, the etching conditions (the amount of electric power applied to a coil-shaped electrode, the amount of electric power applied to an electrode on a substrate side, the temperature of the electrode on the substrate side, or the like) are adjusted as appropriate.

A mixed solution of phosphoric acid, acetic acid, and nitric acid, or the like can be used as an etchant used for wet etching. Alternatively, ITO07N (by Kanto Chemical Co., Inc.) or the like can be used.

Next, the oxide semiconductor layer is subjected to a first heat treatment. The first heat treatment allows the oxide semiconductor layer to be dehydrated or dehydrogenated. The temperature for the first heat treatment is comprised between 300 and 750 °C, and is preferably 400 °C or more and less than the strain point of the substrate. For example, a substrate is introduced into an electric furnace using a resistance heating element or the like, and the oxide semiconductor layer 140 is subjected to heat treatment at 450 °C for an hour under a nitrogen atmosphere. During the treatment, the oxide semiconductor layer 140 is not exposed to air to prevent contamination by water or hydrogen present in the air.

The heat treatment apparatus is not limited to an electric furnace; the heat treatment apparatus can be an apparatus that heats an object using thermal conduction or thermal radiation given by a medium such as a heated gas or the like. For example, an RTA (rapid thermal annealing) apparatus such as a GRTA (gas rapid thermal annealing) apparatus or an LRTA (lamp rapid thermal annealing) apparatus is applicable. An LRTA apparatus is an apparatus that heats an object with radiation of light (an electromagnetic wave) emitted from a lamp such as a halogen lamp, a metal halide lamp, a xenon arc lamp, a carbon arc lamp, a high pressure sodium lamp, or a high pressure mercury lamp. A GRTA apparatus is an apparatus that performs heat treatment using a high-temperature gas. An inert gas which does not react with an object even during the heat treatment, such as nitrogen or a rare gas such as argon is used.

For example, the first heat treatment can employ GRTA, in which the substrate is moved into an inert gas heated at a high temperature of 650 to 700 °C, and heated for several minutes there, and then the substrate is moved out of the inert gas. GRTA enables short-time high-temperature heat treatment. Further, such a short-time heat treatment is applicable even at a temperature exceeding the strain point of the substrate.

Note that in the first heat treatment is preferably used an atmosphere which contains nitrogen or a rare gas (helium, neon, argon, or the like) as its main component and which does not contain water, hydrogen, or the like. For example, the purity of nitrogen or a rare gas such as helium, neon, or argon, which is introduced into the heat treatment apparatus, is preferably 6N (99.9999 %) or more, and preferably 7N (99.99999 %) or more (i.e. the impurity concentration is 1 ppm or less, and preferably 0.1 ppm or less).

The oxide semiconductor layer crystallizes to be microcrystalline or polycrystalline depending on the conditions of the first heat treatment and the composition of the oxide semiconductor layer. For example, the oxide semiconductor layer crystallizes to be a microcrystalline semiconductor layer with a degree of crystallization of 90 % or more, or 80 % or more in some cases. Further, the oxide semiconductor layer becomes an amorphous oxide semiconductor layer containing no crystalline component depending on the conditions of the first heat treatment and the composition of the oxide semiconductor layer.

In some cases, the oxide semiconductor layer becomes an oxide semiconductor layer in which a microcrystalline portion (with a grain diameter of 1 to 20 nm, typically 2 to 4 nm) is mixed into an amorphous oxide semiconductor (e.g. a surface of the oxide semiconductor layer). For example, in the case where the oxide semiconductor layer is formed using an In-Ga-Zn-O based target intended for the deposition of an oxide semiconductor, the electric characteristics of the oxide semiconductor layer can be changed by providing a microcrystalline portion where crystal grains of In₂Ga₂ZnO₇ having electrical anisotropy are aligned. By forming a microcrystalline portion where crystal grains of In₂Ga₂ZnO₇ are aligned at the surface of the oxide semiconductor layer, the oxide semiconductor layer exhibits an enhanced electrical conductivity in a direction parallel to the surface and an enhanced electrical resistivity in a direction perpendicular to the surface. Further, such a microcrystalline portion has the function of preventing impurities such as water and hydrogen from entering the oxide semiconductor layer. Note that the above oxide semiconductor layer can be obtained by heating a surface of the oxide semiconductor layer by GRTA. The use of a sputter target that contains more In or Ga than Zn allows the above oxide semiconductor layer to be formed in a preferable way.

The first heat treatment performed on the oxide semiconductor layer 140 can be performed on the oxide semiconductor layer not yet been processed into the island-shaped oxide semiconductor layer 140. In this case, the substrate is taken out from the heat treatment apparatus after the first heat treatment and then subjected to the photolithography process.

Note that the first heat treatment can also be called a dehydration process or dehydrogenation process because it is effective in dehydrating or dehydrogenating the oxide semiconductor layer 140. It is possible to perform such a dehydration process or dehydrogenation process after forming the oxide semiconductor layer, after forming a source or drain electrode layer over the oxide semiconductor layer 140, or after forming a protective insulating layer over the source or drain electrode. Such a dehydration process or dehydrogenation process can be conducted more than once.

Next, a source or drain electrode 142a and a source or drain electrode 142b are formed so as to be in contact with the oxide semiconductor layer 140 (see FIG. 5F). The source or drain electrode 142a and the source or drain electrode 142b are formed by forming a conductive layer so that the conductive layer covers the oxide semiconductor layer 140 and then selectively etching the conductive layer.

The conductive layer can be formed by PVD such as sputtering or CVD such as plasma CVD. Examples of the material for the conductive layer include an element selected from aluminum, chromium, copper, tantalum, titanium, molybdenum, and tungsten; and an alloy including any of these elements as a component. One or more of materials selected from manganese, magnesium, zirconium, beryllium, and thorium can be alternatively used for the conductive layer. Alternatively, aluminum combined with one or more of elements selected from titanium, tantalum, tungsten, molybdenum, chromium, neodymium, and scandium can be used for the conductive layer. The conductive layer can have either a single-layer structure or a layered structure of two or more layers. A single-layer structure of an aluminum film containing silicon, a two-layer structure in which a titanium film is stacked over an aluminum film, a three-layer structure in which a first titanium film, an aluminum film, and a second titanium film are stacked in this order, and the like can be given as examples.

Here, ultraviolet rays, a KrF laser beam, or an ArF laser beam is preferably used for exposures for making an etching mask. The channel length (L) of the transistor is determined by the distance separating the source or drain electrode 142a and the source or drain electrode 142b on the oxide semiconductor 140. In the case where the channel length (L) is less than 25 nm, exposures for making a mask are performed in the extreme ultraviolet range of extremely short wavelength of several nanometers to several tens of nanometers. Exposures in the extreme ultraviolet range yield high resolution and a great depth of focus. Therefore, the channel length (L) of a transistor, which is formed later, can be 10 to 1000 nm, and thus the operation rate of the circuit can be increased. Further, since the off-state current is extremely low, the power consumption is not increased even in the case of fine patterning.

Each material and the etching conditions are adjusted as appropriate in order that the oxide semiconductor layer 140 may not be removed in the etching of the conductive layer. In this step, the oxide semiconductor layer 140 may be partly etched to be an oxide semiconductor layer having a groove (a depressed portion) depending on the composition of the oxide semiconductor layer and the etching conditions.

An oxide conductive layer can be formed between the oxide semiconductor layer 140 and the source or drain electrode 142a or between the oxide semiconductor layer 140 and the source or drain electrode 142b. It is possible to successively form the oxide conductive layer and a metal layer which is to be the source or drain electrode 142a or the source or drain electrode 142b (successive deposition). The oxide conductive layer can function as a source region or a drain region. Such an oxide conductive layer leads to the reduction in the electrical resistance of the source region or a drain region, and thus high-speed operation of the transistor is achieved.

In order to reduce the number of the masks used or of fabrication steps, etching can be performed using a resist mask made by a gray-tone mask which is a light-exposure mask such that light transmitted by the mask has a plurality of intensities. A resist mask made by a gray-tone mask has a plurality of thicknesses and can be further changed in shape by ashing; thus, such a resist mask can be used in a plurality of etching steps for different patterns. In other words, a resist mask applicable to at least two or more kinds of different patterns can be made by a single gray-tone mask. This reduces the number of exposure masks and also the number of corresponding photolithography steps, thereby simplifying the process.

Note that plasma treatment using a gas such as N₂O, N₂, and Ar is preferably conducted after the above process. The plasma treatment removes water or the like that adheres to an exposed surface of the oxide semiconductor layer. The plasma treatment can use a mixed gas of oxygen and argon.

Next, a protective insulating layer 144 which is in contact with part of the oxide semiconductor layer 140 is formed without exposure to air during the formation steps (see FIG. 5G).

The protective insulating layer 144 is formed to a thickness of 1 nm or more and can be formed using as appropriate a method, such as sputtering, by which an impurity such as water or hydrogen is prevented from entering the protective insulating layer 144. Examples of the material for the protective insulating layer 144 include silicon oxide, silicon nitride, silicon oxynitride, and silicon nitride oxide. Its structure can be either a single-layer structure or a layered structure. The substrate temperature for the deposition of the protective insulating layer 144 is preferably room temperature or more and 300 °C or less. The atmosphere for the deposition of the protective insulating layer 144 is preferably a rare gas (typically argon) atmosphere, an oxygen atmosphere, or a mixed atmosphere of a rare gas (typically argon) and oxygen.

The mixing of hydrogen into the protective insulating layer 144 causes contamination of the oxide semiconductor layer by hydrogen, the stripping of oxygen from the oxide semiconductor layer due to hydrogen, or the like, whereby the resistance of the backchannel of the oxide semiconductor layer may be reduced and a parasitic channel may be formed. Therefore, it is important not to use hydrogen when forming the protective insulating layer 144 in order to minimize entry of hydrogen in the protective insulating layer 144.

It is preferable to form the protective insulating layer 144 while removing moisture remaining in the treatment chamber. This is in order to prevent hydrogen, hydroxyl, or water from entering the oxide semiconductor layer 140 and the protective insulating layer 144.

In order to remove moisture remaining in the treatment chamber, a sorption vacuum pump is preferably used. For example, a cryopump, an ion pump, or a titanium sublimation pump is preferably used. The evacuation unit can be a turbo pump provided with a cold trap. A hydrogen atom, a compound containing a hydrogen atom, such as water (H₂O), and the like are removed from the deposition chamber when evacuated with the cryopump, thereby reducing the impurity concentration of the protective insulating layer 144 formed in the deposition chamber.

A sputtering gas for the deposition of the protective insulating layer 144 is preferably a high-purity gas in which the concentration of impurities such as hydrogen, water, hydroxyl, and hydride is reduced to approximately several parts per million (preferably approximately several parts per billion).

Next, a second heat treatment is performed, preferably in an inert gas atmosphere or oxygen gas atmosphere (preferably at 200 to 400 °C, e.g. 250 to 350 °C). For example, the second heat treatment is performed in a nitrogen atmosphere at 250 °C for one hour. The second heat treatment can reduce variations between transistors in electric characteristics.

Heat treatment can be performed at 100 to 200 °C for 1 to 30 hours in an air atmosphere. This heat treatment can be performed at a fixed heating temperature or follow temperature cycles where the temperature repeatedly rises from room temperature to a heating temperature of 100 to 200 °C and drops from the a heating temperature to room temperature. This heat treatment can be performed before the deposition of the protective insulating layer under a reduced pressure. Heat treatment under reduced pressure shortens the heating time. Note that this heat treatment can be performed instead of the second heat treatment or after the second heat treatment.

Next, an interlayer insulating layer 146 is formed over the protective insulating layer 144 (see FIG. 6A). The interlayer insulating layer 146 can be formed by PVD, CVD, or the like. In addition, the interlayer insulating layer 146 can be formed using a material containing an inorganic insulating material, such as silicon oxide, silicon nitride oxide, silicon nitride, hafnium oxide, aluminum oxide, and tantalum oxide. After the interlayer insulating layer 146 is formed, a surface thereof is preferably flattened by CMP, etching, or the like.

Next, openings reaching the electrode 136a, the electrode 136b, the source or drain electrode 142a, and the source or drain electrode 142b are formed in the interlayer insulating layer 146, the protective insulating layer 144, and the gate insulating layer 138. Then, a conductive layer 148 is formed so as to be embedded in the openings (see FIG. 6B). The openings can be formed by etching using a mask. The mask can be made by exposures using a photomask, for example. Either wet etching or dry etching can be used as the etching; in case of a fine patterning, dry etching is preferably used. The conductive layer 148 can be formed by a deposition method such as PVD and CVD. Examples of the material for the conductive layer 148 include a conductive material such as molybdenum, titanium, chromium, tantalum, tungsten, aluminum, copper, neodymium, and scandium; and an alloy and compound (e.g. nitride) of any of these materials.

Specifically, the method can employ a thin titanium film formed by PVD in a region including openings, a thin titanium nitride film formed by CVD, and a tungsten film formed so as to fill the openings. Here, the titanium film formed by PVD has a function of reducing an oxide film at an interface with a lower electrode (here, the electrode 136a, the electrode 136b, the source or drain electrode 142a, or the source or drain electrode 142b), and thus reducing contact resistance to the lower electrode. The titanium nitride film to be formed afterwards a barrier function of blocking the diffusion of the conductive material.

After the conductive layer 148 is formed, part of the conductive layer 148 is removed by etching or CMP, and the interlayer insulating layer 146 is thus exposed, thereby forming the electrode 150a, the electrode 150b, the electrode 150c, and the electrode 150d (see FIG. 6C). Note that when the electrode 150a, the electrode 150b, the electrode 150c, and the electrode 150d are formed by removing part of the conductive layer 148, it is preferable that a surface be processed to be flat. Adequate electrodes, wirings, insulating layers, semiconductor layers, or the like can be formed in the later steps by such an improvement in the flatness of a surface of the interlayer insulating layer 146, the electrode 150a, the electrode 150b, the electrode 150c, and the electrodes 150d.

Further, an insulating layer 152 is formed, and openings reaching the electrode 150a, the electrode 150b, the electrode 150c, and the electrode 150d are formed in the insulating layer 152. Then, a conductive layer is formed so as to fill the openings. After that, part of the conductive layer is removed by etching or CMP, and the insulating layer 152 is thus exposed, thereby forming an electrode 154a, an electrode 154b, and an electrode 154c (see FIG. 6D). This process is similar to that of forming the electrode 150a and the like previously described, and the details are therefore omitted.

When the n-type transistor 162 is formed in the above manner, the hydrogen concentration of the oxide semiconductor layer 140 is 5×10¹⁹ atoms/cm³ or less, and the off-state current of the n-type transistor 162 is 1×10⁻¹³ A or less, and preferably 100 zA/µm or less. The use of such an oxide semiconductor layer 140 with high purity produced by an adequate reduction in hydrogen concentration produces the n-type transistor 162 having excellent characteristics and also produces a semiconductor device having excellent characteristics which has a p-type transistor in its lower part and an n-type transistor using an oxide semiconductor in its upper part.

A combination of a transistor using a material other than an oxide semiconductor and a transistor using an oxide semiconductor allows for the production of a semiconductor device requiring electric characteristics different from those of transistors using an oxide semiconductor (e.g. difference in carriers characteristics, which have an effect on the behavior of the element).

A transistor using an oxide semiconductor has good switching characteristics, so that an excellent semiconductor device utilizing these characteristics can be made. For example, a CMOS inverter circuit can adequately reduce flow-through current, thereby reducing the power consumption of the semiconductor device and preventing damage to the semiconductor device due to a heavy current. On the other hand, a transistor using an oxide semiconductor has extremely low off-state current, thereby reducing the power consumption of the semiconductor device.

Note that although in this embodiment the case where the p-type transistor 160 and the n-type transistor 162 are stacked is described as an example, the semiconductor device according to this embodiment is not limited to this; the p-type transistor 160 and the n-type transistor 162 can be formed over the same substrate. Moreover, although in this embodiment the case where the channel length direction of the p-type transistor 160 is perpendicular to the channel length direction of the n-type transistor 162 is described as an example, the physical relationship between the p-type transistor 160 and the n-type transistor 162 is not limited to this. In addition, the p-type transistor 160 and the n-type transistor 162 can overlap with each other.

The methods and structures described in this embodiment can be combined as appropriate with any of those described in the other embodiments.

### (Embodiment 2)

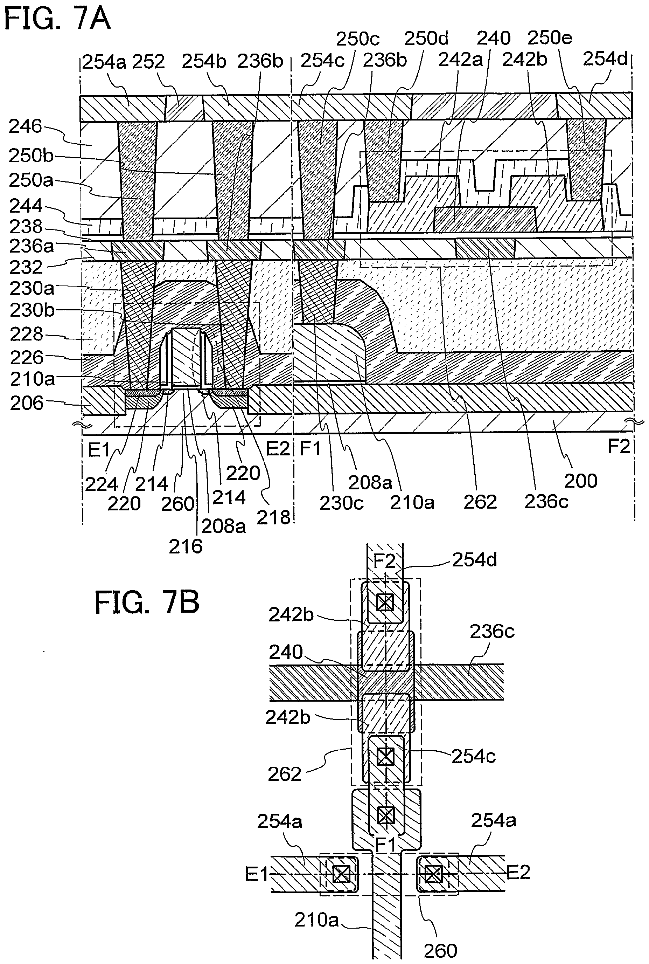

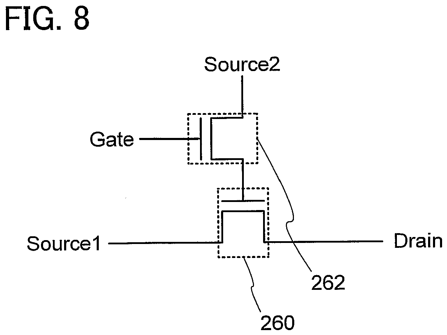

In this embodiment, the structure of a semiconductor device according to the disclosed invention is described with reference to FIGS. 7A and 7B and FIG. 8. Note that in this embodiment, the structure of a semiconductor device which can be used as a memory element is described.

FIG. 7A shows a cross-sectional view of a semiconductor device according to this embodiment. FIG. 7B shows a plane view of the semiconductor device according to this embodiment. Here, FIG. 7A shows section E1-E2 and section F1-F2 of FIG. 7B. The semiconductor device shown in FIGS. 7A and 7B includes a transistor 260 in its lower part, which is formed using silicon, and a transistor 262 in its upper part, which is formed using an oxide semiconductor.

The transistor 260 using silicon includes: a channel formation region 216 in a substrate 200 containing silicon, impurity regions 214 and heavily doped regions 220, collectively called simply impurity regions, impurity regions between which is interposed the channel formation region 216, a gate insulating layer 208a over the channel formation region 216; a gate electrode 210a over the gate insulating layer 208a; a source or drain electrode 230a electrically connected to a first impurity region 214 on one side of the channel formation region 216; and a source or drain electrode 230b electrically connected to a second impurity region 214 on another side of the channel formation region 216. Note that, preferably, the source or drain electrode 230a is electrically connected to the first impurity region 214 on the one side of the channel formation region 216 through a first metal compound region 224 on the one side of the channel formation region 216, and the source or drain electrode 230b is electrically connected to the second impurity region 214 on the other side of the channel formation region 216 through a second metal compound region 224 on the other side the channel formation region 216. As described above, the structure of the transistor 260 is similar to that of the p-type transistor 160 described in Embodiment 1, and thus other details of the transistor 260 can be seen in Embodiment 1. Note that the transistor 260 can be either a p-type transistor or an n-type transistor.

The transistor 262 using an oxide semiconductor includes: a gate electrode 236c over an insulating layer 228, a gate insulating layer 238 over the gate electrode 236c, an oxide semiconductor layer 240 over the gate insulating layer 238, and source or drain electrodes 242a and 242b which are over the oxide semiconductor layer 240 and electrically connected to the oxide semiconductor layer 240. As described above, the structure of the transistor 262 is similar to that of the n-type transistor 162 described in Embodiment 1, and thus other details of the transistor 262 can be seen in Embodiment 1. Note that the transistor 262 can be either an n-type transistor or a p-type transistor.

Next, electrical connections of the transistor 260 and the transistor 262 will be described. The source or drain electrode 230a in the transistor 260 is electrically connected to a first wiring through an electrode 236a, an electrode 250a, an electrode 254a, and the like. The source or drain electrode 230b in the transistor 260 is electrically connected to a second wiring through an electrode 236b, an electrode 250b, an electrode 254b, and the like.

The source or drain electrode 242a of the transistor 262 is electrically connected to the gate electrode 210a of the transistor 260 through an electrode 250d, an electrode 254c, an electrode 250c, an electrode 236b, and an electrode 230c. The source or drain electrode 242b of the transistor 262 is electrically connected to a third wiring through an electrode 250e, an electrode 254d, and the like.

Note that in FIGS. 7A and 7B, an element isolation insulating layer 206 corresponds to the element insulation insulating layer 106 in Embodiment 1; side wall insulating layers 218 to the side wall insulating layers 118 in Embodiment 1; an interlayer insulating layer 226 to the interlayer insulating layer 126 in Embodiment 1; an insulating layer 232 to the insulating layer 132 in Embodiment 1; a protective insulating layer 244 to the protective insulating layer 144 in Embodiment 1; an interlayer insulating layer 246 to the interlayer insulating layer 146 in Embodiment 1; and an insulating layer 252 to the insulating layer 152 in Embodiment 1. In accordance with the invention, the insulating layer 228 or the interlayer insulating layer 246 is an aluminum oxide layer.

FIG. 8 shows an example of the diagram of a circuit using the above semiconductor device as a memory element.

The source electrode of the transistor 260 using silicon is electrically connected to a first source wiring (Source 1). The drain electrode of the transistor 260 using silicon is electrically connected to a drain wiring (Drain). The gate electrode of the transistor 260 using silicon is electrically connected to the drain electrode of the transistor 262 using an oxide semiconductor.

The source electrode of the transistor 262 using an oxide semiconductor is electrically connected to a second source wiring (Source 2). The gate electrode of the transistor 262 using an oxide semiconductor is electrically connected to a gate wiring (Gate).

Here, the transistor 262 using an oxide semiconductor is characterized by extremely low off-state current. Therefore, when the transistor 262 is placed in an off state, the potential of the gate electrode of the transistor 260 can be held for extremely long periods of time.

The semiconductor device can serve as a memory element by making use of the characteristics of the transistor 262 which holds the potential of the gate electrode, for example by carrying out the following operation. First, the potential of the gate wiring (Gate) becomes a potential that turns on the transistor 262, and thus the transistor 262 is turned on. This allows the potential of the second source wiring (Source 2) to be applied to the gate electrode of the transistor 260 (write operation). After that, the potential of the gate wiring (Gate) becomes a potential that turns off the transistor 262, and thus the transistor 262 is turned off.

Since the off-state current of the transistor 262 is extremely low, the potential of the gate electrode of the transistor 260 can be held for extremely long periods of time. Specifically, for example, when the potential of the gate electrode of the transistor 260 is a potential that turns on the transistor 260, the transistor 260 is held in an on state for long periods of time. On the other hand, when the potential of the gate electrode of the transistor 260 is a potential that turns off the transistor 260, the transistor 260 is held in an off state for long periods of time.

Therefore, the value of the potential of the drain wiring (Drain) changes depending on the potential held by the gate electrode of the transistor 260. For example, when the potential of the gate electrode of the transistor 260 is a potential that turns on the transistor 260, the transistor 260 is held in an on-state, so that the potential of the drain wiring (Drain) becomes equal to the potential of the first source wiring (Source 1). As described above, the value of the potential of the drain wiring (Drain) changes depending on the potential of the gate electrode of the transistor 260, and the semiconductor device serves as a memory element by reading this changing value (read operation).

It is possible to use the semiconductor device according to this embodiment as a substantial non-volatile memory element because the semiconductor device enables data to be held for extremely long periods of time using the off-state current characteristics of the transistor 262.

Note that although in this embodiment only an elementary unit of a memory element is described for easy understanding, the structure of the semiconductor device is not limited to this. It is also possible to make a more developed semiconductor device with a plurality of memory elements interconnected to each other as appropriate. For example, it is possible to make a NAND-type or NOR-type semiconductor device by using more than one of the above memory elements. In addition, wiring connections are not limited to those in FIG. 8 and can be changed as appropriate.

As described above, one embodiment of the present invention forms a substantially non-volatile memory element using the off-state current characteristics of the transistor 262. Thus, one embodiment of the present invention provides a semiconductor device with a new structure.

The methods and structures described in this embodiment can be combined as appropriate with any of those described in the other embodiments.

### (Embodiment 3)

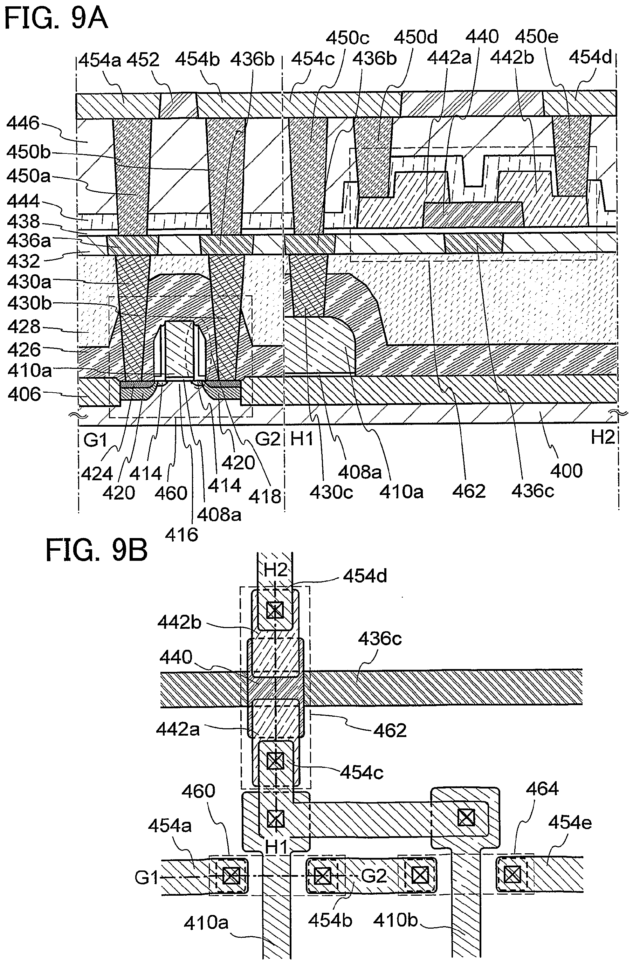

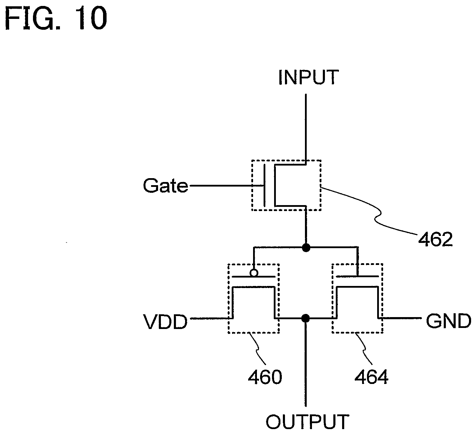

In this embodiment, the structure of a semiconductor device according to another embodiment of the disclosed invention is described with reference to FIGS. 9A and 9B and FIG. 10. Note that in this embodiment, the structure of a semiconductor device which can be used as a memory element is described.

FIG. 9A shows a cross-sectional view of a semiconductor device according to this embodiment. FIG. 9B shows a plane view of the semiconductor device according to this embodiment. Here, FIG. 9A shows section G1-G2 and section H1-H2 in FIG. 9B. The semiconductor device shown in FIGS. 9A and 9B includes, in its lower part, a p-type transistor 460 and an n-type transistor 464 which are formed using silicon, and includes, in its upper part, a transistor 462 using an oxide semiconductor.

The p-type transistor 460 and the n-type transistor 464 which are formed using silicon have a similar structure to that of the p-type transistor 160, the transistor 260, or the like in Embodiments 1 and 2. The transistor 462 using an oxide semiconductor has a similar structure to that of the n-type transistor 162, the transistor 262, or the like in Embodiments 1 and 2. Therefore, the components of these transistors are also based on those of the transistors in Embodiments 1 and 2. The details can be seen in Embodiments 1 and 2.

Note that in FIGS. 9A and 9B, a substrate 400 corresponds to the substrate 100 in Embodiment 1; an element isolation insulating layer 406 to the element insulation insulating layer 106 in Embodiment 1; a gate insulating layer 408a to the gate insulating layer 108a in Embodiment 1; a gate electrode 410a to the gate electrode 110a in Embodiment 1; a gate wiring 410b to the gate wiring 110b in Embodiment 1; impurity regions 414 to the impurity regions 114 in Embodiment 1; a channel formation region 416 to the channel formation region 116 in Embodiment 1; side wall insulating layers 418 to the side wall insulating layers 118 in Embodiment 1; heavily doped regions 420 to the heavily doped regions 120 in Embodiment 1; metal compound regions 424 to the metal compound regions 124 in Embodiment 1; an interlayer insulating layer 426 to the interlayer insulating layer 126 in Embodiment 1; an interlayer insulating layer 428 to the interlayer insulating layer 128 in Embodiment 1; a source or drain electrode 430a to the source or drain electrode 130a in Embodiment 1; a source or drain electrode 430b to the source or drain electrode 130b in Embodiment 1; and a source or drain electrode 430c to the source or drain electrode 130e in Embodiment 2.

In addition, an insulating layer 432 corresponds to the insulating layer 132 in Embodiment 1; an electrode 436a to the electrode 136a in Embodiment 1; an electrode 436b to the electrode 136b in Embodiment 1; a gate electrode 436c to the gate electrode 136c in Embodiment 1; a gate insulating layer 438 to the gate insulating layer 138 in Embodiment 1; an oxide semiconductor layer 440 to the oxide semiconductor layer 140 in Embodiment 1; a source or drain electrode 442a to the source or drain electrode 142a in Embodiment 1; a source or drain electrode 442b to the source or drain electrode 142b in Embodiment 1; a protective insulating layer 444 to the protective insulating layer 144 in Embodiment 1; an interlayer insulating layer 446 to the interlayer insulating layer 146 in Embodiment 1; an electrode 450a to the electrode 150a in Embodiment 1; an electrode 450b to the electrode 150b in Embodiment 1; an electrode 450c to the electrode 150b in Embodiment 1; an electrode 450d to the electrode 150c in Embodiment 1; an electrode 450e to the electrode 150d in Embodiment 1; an insulating layer 452 to the insulating layer 152 in Embodiment 1; an electrode 454a to the electrode 154a in Embodiment 1; an electrode 454b to the electrode 154b in Embodiment 1; an electrode 454c to the electrode 154b in Embodiment 1; and an electrode 454d to the electrode 154c in Embodiment 1. In accordance with the invention, interlayer insulating layer 428 or interlayer insulating layer 446 is an aluminum oxide layer.

The semiconductor device according to this embodiment is different from the semiconductor device according to Embodiment 1 or 2 in having the drain electrode of the transistor 462, the gate electrode of the p-type transistor 460, and the gate electrode of the n-type transistor 464 electrically connected to each other (see FIGS. 9A and 9B). This structure allows an input signal (INPUT) of the CMOS inverter circuit to be temporarily held.

The methods and structures described in this embodiment can be combined as appropriate with any of those described in the other embodiments.

### (Embodiment 4)

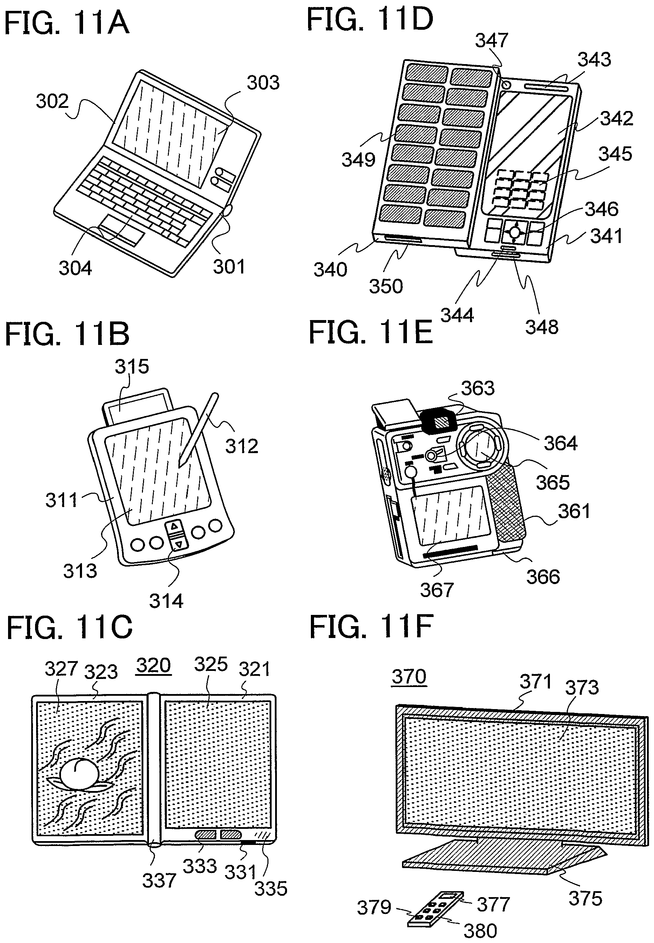

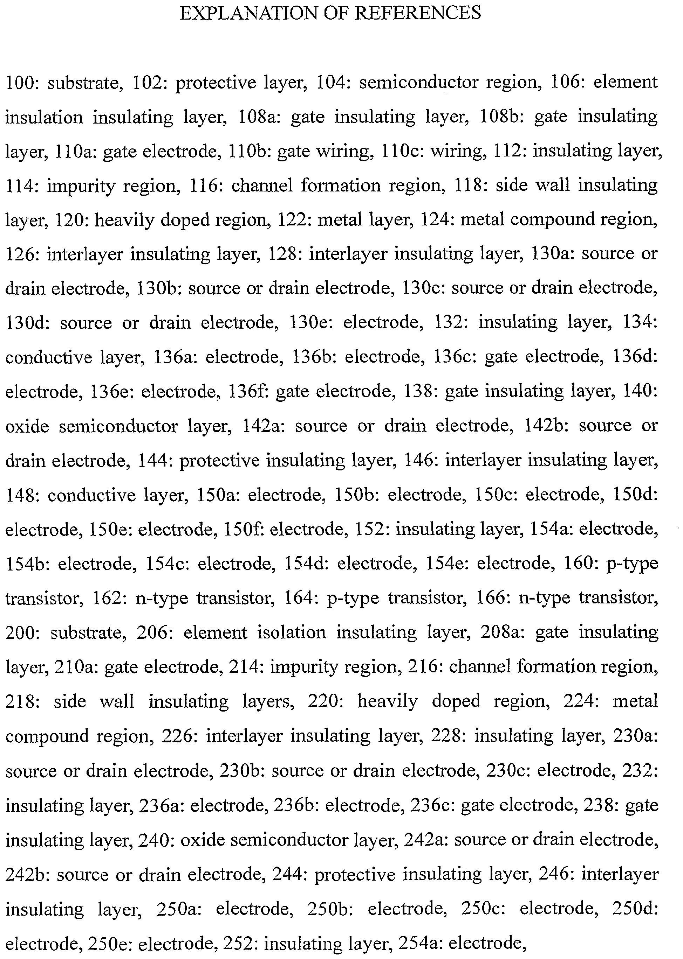

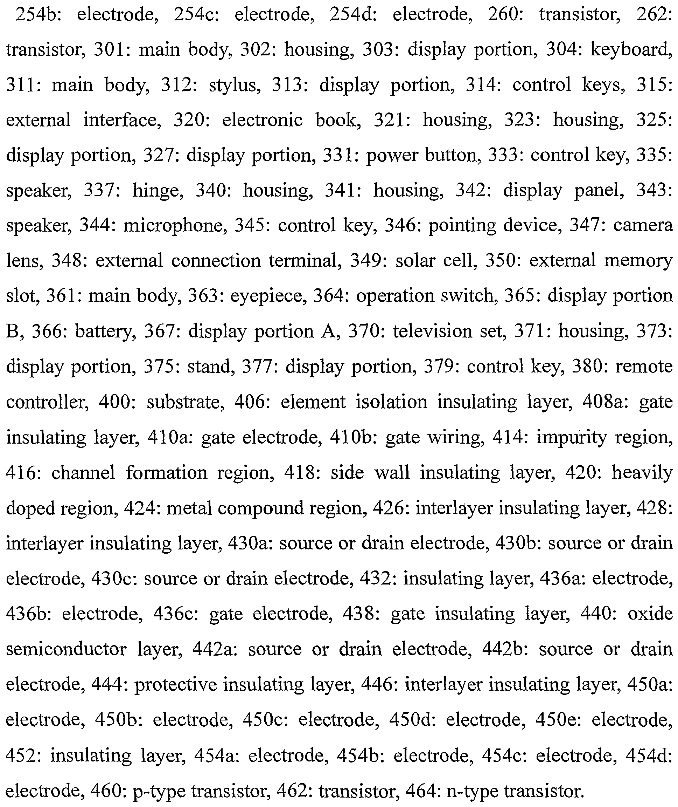

In this embodiment, examples of electronic appliances equipped with the semiconductor device according to any of Embodiments 1, 2, and 3 are described with reference to FIGS. 11A to 11F. The semiconductor device according to any of Embodiments 1, 2, and 3 includes a transistor using an oxide semiconductor with good switching characteristics, and thus can reduce the power consumption of the electronic appliance. In addition, a semiconductor device with a new structure using the characteristics of oxide semiconductors (e.g. a memory element) allows for the achievement of an appliance with a new structure. Note that the semiconductor device according to any of Embodiments 1, 2, and 3 can be mounted on a circuit substrate or the like alone or integrated with other components, and thus built into the electronic appliance.

In many cases, an integrated circuit into which the semiconductor device is integrated includes a variety of circuit components such as a resistor, a capacitor, and a coil in addition to the semiconductor device according to any of Embodiments 1, 2, and 3. An example of the integrated circuit is a circuit into which an arithmetic circuit, a converter circuit, an amplifier circuit, a memory circuit, and circuits relating to any of these circuits are highly integrated. It can be said that MPUs (Microprocessor Units) and CPUs (Central Processing Units) are typical examples of the above.

The semiconductor device is applicable to a switching element or the like in a display device. In this case, the semiconductor device and a driver circuit are preferably provided over the same substrate. Naturally it is also possible to use the semiconductor device only for a driver circuit of the display device.

FIG. 11A shows a notebook PC including the semiconductor device according to any of Embodiments 1, 2, and 3. The notebook PC includes a main body 301, a housing 302, a display portion 303, a keyboard 304, and the like.

FIG. 11B shows a personal digital assistant (PDA) including the semiconductor device according to any of Embodiments 1, 2, and 3. The personal digital assistant includes a main body 311 provided with a display portion 313, an external interface 315, operational keys 314, and the like. In addition, the personal digital assistant includes a stylus 312 which is an accessory for operation.

FIG. 11C shows an electronic book 320 as an example of the electronic paper including the semiconductor device according to any of Embodiments 1, 2, and 3. The electronic book 320 includes two housings: a housing 321 and a housing 323. The housing 321 is combined with the housing 323 by a hinge 337, so that the electronic book 320 can be opened and closed using the hinge 337 as an axis. Such a structure allows the same use of the electronic book 320 as that of paper books.

The housing 321 includes a display portion 325, and the housing 323 includes a display portion 327. The display portion 325 and the display portion 327 can display a continuous image or different images. The structure for displaying different images enables text to be displayed on the right display portion (the display portion 325 in FIG. 11C) and images to be displayed on the left display portion (which is the display portion 327 in FIG. 11C).

FIG. 11C shows an example of the case where the housing 321 includes an operating portion. For example, the housing 321 includes a power button 331, control keys 333, a speaker 335, and the like. The control keys 333 allow pages to be turned. Note that a keyboard, a pointing device, or the like can also be provided on the same face as the display portion. Furthermore, an external connection terminal (an earphone terminal, a USB terminal, a terminal connectable to various cables such as an AC adapter and a USB cable, or the like), a recording medium insertion portion, and the like can be provided on the back surface or a side surface of the housing. The electronic book 320 can also serve as an electronic dictionary.

In addition, the electronic book 320 can send and receive information wirelessly. Through wireless communication, desired book data or the like can be purchased and downloaded from an electronic book server.

Note that electronic paper can be used for electronic appliances in all fields as long as they display data. For example, to display data, electronic paper can be applied to posters, advertisement in vehicles such as trains, a variety of cards such as credit cards, and so on in addition to electronic books.

FIG. 11D shows a mobile phone including the semiconductor device according to any of Embodiments 1, 2, and 3. The mobile phone includes two housings: a housing 340 and a housing 341. The housing 341 includes a display panel 342, a speaker 343, a microphone 344, a pointing device 346, a camera lens 347, an external connection terminal 348, and the like. The housing 340 includes a solar cell 349 charging the mobile phone, an external memory slot 350, and the like. An antenna is built in the housing 341.

The display panel 342 includes a touch panel. A plurality of control keys 345 which is displayed as an image is shown by dashed lines in FIG. 11D. Note that the mobile phone includes a booster circuit for increasing a voltage output from the solar cell 349 to a voltage needed for each circuit. It is possible for the mobile phone to have, in addition to the above structure, a structure in which a noncontact IC chip, a small recording device, or the like are formed.

The display orientation of the display panel 342 changes as appropriate in accordance with the application mode. Further, the camera lens 347 is provided on the same face as the display panel 342, so that the mobile phone can be used as a video phone. The speaker 343 and the microphone 344 can be used for videophone calls, recording, and playing sound, etc. as well as voice calls. Moreover, the housings 340 and 341 which are shown unfolded in FIG. 11D can overlap with each other by sliding. Thus, the mobile phone can be in a suitable size for portable use.

The external connection terminal 348 is connectable to an AC adaptor and a variety of cables such as a USB cable, which enables charging of the mobile phone and data communication between the mobile phone and a personal computer or the like. Moreover, a larger amount of data can be saved and moved by inserting a recording medium to the external memory slot 350. The mobile phone can be capable of, in addition to the above, infrared communication, television reception, or the like.

FIG. 11E shows a digital camera including the semiconductor device according to any of Embodiments 1, 2, and 3. The digital camera includes a main body 361, a display portion A 367, an eyepiece 363, an operation switch 364, a display portion B 365, a battery 366, and the like.

FIG. 11F shows a television set including the semiconductor device according to any of Embodiments 1, 2, and 3. A television set 370 has a housing 371 including a display portion 373. Images can be displayed on the display portion 373. Here, the housing 371 is supported by a stand 375.

The television set 370 can be operated by an operation switch included in the housing 371 or by a remote controller 380. Channels and volume can be controlled by a control key 379 included in the remote controller 380, and images displayed on the display portion 373 can thus be controlled. Further, the remote controller 380 can be provided with a display portion 377 displaying data from the remote controller 380.

Note that the television set 370 preferably includes a receiver, a modem, and the like. The receiver allows the television set 370 to receive a general television broadcast. In addition, the television set 370 is capable of one-way (from a transmitter to a receiver) or two-way (between a transmitter and a receiver, between receivers, or the like) data communication when connected to a communication network by wired or wireless connection via the modem.

The methods and structures described in this embodiment can be combined as appropriate with any of those described in the other embodiments.

## Claims

1. A semiconductor device comprising:
a first transistor (260) comprising a channel formation region (216) in a substrate (200) containing a semiconductor material, impurity regions (214) formed with the channel formation region (216) interposed therebetween, a first gate insulating layer (208a) over the channel formation region (216), a first gate electrode (210a) over the first gate insulating layer (208a), and a first source electrode (230a) and a first drain electrode (230b) which are electrically connected to the impurity regions (214);
a second transistor (262) comprising a second gate electrode (236c) over the substrate (200) containing the semiconductor material, a second gate insulating layer (238) over the second gate electrode (236c), an oxide semiconductor layer (240) over the second gate insulating layer (238), and a second source electrode (242a) and a second drain electrode (242b) which are electrically connected to the oxide semiconductor layer (240);
a first insulating layer (228) interposed between the first transistor (260) and the second transistor (262) and a third insulating layer (246) over the second transistor (262);
an interlayer insulating layer (226) over the first transistor (260), the first insulating layer (228) arranged over the interlayer insulating layer (226);
a second insulating layer (232) and first embedded electrodes (236a-236c) on and in contact with the first insulating layer (228) and below the second gate insulating layer (238), the first embedded electrodes being embedded in the second insulating layer (232);
a protective insulating layer (244) over the oxide semiconductor layer (240) and in contact with part of the oxide semiconductor layer (240), and
a fourth insulating layer (252) and second embedded electrodes (254a-254d) embedded in the fourth insulating layer (252), the fourth insulating layer (252) being on and in contact with the third insulating layer (246), and the second embedded electrodes (254a-254d) being over the third insulating layer (246),
wherein the first source electrode (230a) and the first drain electrode (230b) are each formed through a respective opening in the interlayer insulating layer (226) and in the first insulating layer (228),
wherein one of the first embedded electrodes (236a-236c) forms the second gate electrode (236c) of the second transistor (262),
wherein the first insulating layer (228) or the third insulating layer (246) is an aluminum oxide layer,
wherein the third insulating layer (246) is arranged over the protective insulating layer (244),
wherein the first gate electrode (210a) is electrically connected to one of the second source electrode (242a) and the second drain electrode (242b) through an electrode (230c) formed through a further opening in the interlayer insulating layer (226) and in the first insulating layer (228), one embedded electrode (236b) of the first embedded electrodes (236a-236c), a first electrode (250c) formed through a first opening in the third insulating layer (246) and in the protective insulating layer (244), one embedded electrode (254c) of the second embedded electrodes (254a-254d), and a second electrode (250d) formed through a second opening in the third insulating layer (246) and in the protective insulating layer (244), the second electrode (250d) being in contact with said one of the second source electrode (242a) and the second drain electrode (242b), and
wherein the semiconductor material is silicon.

2. The semiconductor device according to claim 1,
wherein the semiconductor device is a non-volatile memory.

3. The semiconductor device according to any one of claim 1 to claim 2,
wherein the first transistor (260) is a p-type transistor; and
wherein the second transistor (262) is an n-type transistor.

4. The semiconductor device according to any one of claim 1 to claim 3, wherein the substrate (200) containing the semiconductor material is a single crystal semiconductor substrate or an SOI substrate.

5. The semiconductor device according to any one of claim 1 to claim 4, wherein the oxide semiconductor layer (240) contains an In-Ga-Zn-O based oxide semiconductor material.

6. The semiconductor device according to any one of claim 1 to claim 5, wherein the oxide semiconductor layer (240) contains an In₂Ga₂ZnO₇ crystal.

7. The semiconductor device according to any one of claim 1 to claim 6, wherein a hydrogen concentration of the oxide semiconductor layer (240) is 5×10¹⁹ atoms/cm³ or less.

8. The semiconductor device according to claim 7, wherein the second transistor is an n-type transistor, and due to said hydrogen concentration of the oxide semiconductor layer (240) of 5∗10¹⁹ atoms/cm³ or less, an off-state current of the second transistor (262) is 1×10⁻¹³ A or less at a drain voltage V_{d} of 1 or 10 V and a gate voltage V_{g} ranging from -20 to -5 V.

## Patentansprüche

1. Halbleitervorrichtung, die umfasst:
einen ersten Transistor (260), der einen Kanalbildungsbereich (216) in einem Substrat (200), das ein Halbleitermaterial enthält, Verunreinigungsbereiche (214), die derart ausgebildet sind, dass der Kanalbildungsbereich (216) dazwischen liegt, eine erste Gate-Isolierschicht (208a) über dem Kanalbildungsbereich (216), eine erste Gate-Elektrode (210a) über der ersten Gate-Isolierschicht (208a) und eine erste Source-Elektrode (230a) sowie eine erste Drain-Elektrode (230b) umfasst, die elektrisch mit den Verunreinigungsbereichen (214) verbunden sind;
einen zweiten Transistor (262), der eine zweite Gate-Elektrode (236c) über dem Substrat (200), das das Halbleitermaterial enthält, eine zweite Gate-Isolierschicht (238) über der zweiten Gate-Elektrode (236c), eine Oxidhalbleiterschicht (240) über der zweiten Gate-Isolierschicht (238) und eine zweite Source-Elektrode (242a) sowie eine zweite Drain-Elektrode (242b) umfasst, die elektrisch mit der Oxidhalbleiterschicht (240) verbunden sind;
eine erste Isolierschicht (228), die zwischen dem ersten Transistor (260) und dem zweiten Transistor (262) angeordnet ist, und eine dritte Isolierschicht (246) über dem zweiten Transistor (262);
eine Zwischenschicht-Isolierschicht (226) über dem ersten Transistor (260), wobei die erste Isolierschicht (228) über der Zwischenschicht-Isolierschicht (226) angeordnet ist;
eine zweite Isolierschicht (232) und erste eingebettete Elektroden (236a-236c) auf und in Kontakt mit der ersten Isolierschicht (228) und unterhalb der zweiten Gate-Isolierschicht (238), wobei die ersten eingebetteten Elektroden in die zweite Isolierschicht (232) eingebettet sind;
eine schützende Isolierschicht (244) über der Oxidhalbleiterschicht (240) und in Kontakt mit einem Teil der Oxidhalbleiterschicht (240), und
eine vierte Isolierschicht (252) und zweite eingebettete Elektroden (254a-254d), die in die vierte Isolierschicht (252) eingebettet sind, wobei die vierte Isolierschicht (252) auf und in Kontakt mit der dritten Isolierschicht (246) ist und die zweiten eingebetteten Elektroden (254a-254d) über der dritten Isolierschicht (246) liegen,
wobei die erste Source-Elektrode (230a) und die erste Drain-Elektrode (230b) jeweils durch eine entsprechende Öffnung in der Zwischenschicht-Isolierschicht (226) und in der ersten Isolierschicht (228) ausgebildet sind,
wobei eine der ersten eingebetteten Elektroden (236a-236c) die zweite Gate-Elektrode (236c) des zweiten Transistors (262) bildet,
wobei die erste Isolierschicht (228) oder die dritte Isolierschicht (246) eine Aluminiumoxidschicht ist,
wobei die dritte Isolierschicht (246) über der schützenden Isolierschicht (244) angeordnet ist,
wobei die erste Gate-Elektrode (210a) elektrisch mit einer von der zweiten Source-Elektrode (242a) und der zweiten Drain-Elektrode (242b) über eine Elektrode (230c), die durch eine weitere Öffnung in der Zwischenschicht-Isolierschicht (226) und in der ersten Isolierschicht (228) ausgebildet ist, eine eingebettete Elektrode (236b) der ersten eingebetteten Elektroden (236a-236c), eine erste Elektrode (250c), die durch eine erste Öffnung in der dritten Isolierschicht (246) und in der schützenden Isolierschicht (244) ausgebildet ist, eine eingebettete Elektrode (254c) der zweiten eingebetteten Elektroden (254a-254d) und über eine zweite Elektrode (250d) verbunden ist, die durch eine zweite Öffnung in der dritten Isolierschicht (246) und in der schützenden Isolierschicht (244) ausgebildet ist, wobei die zweite Elektrode (250d) in Kontakt mit der einen von der zweiten Source-Elektrode (242a) und der zweiten Drain-Elektrode (242b) ist, und
wobei das Halbleitermaterial Silizium ist.

2. Halbleitervorrichtung nach Anspruch 1,
wobei die Halbleitervorrichtung ein nichtflüchtiger Speicher ist.

3. Halbleitervorrichtung nach einem der Ansprüche 1 bis 2,
wobei der erste Transistor (260) ein p-Typ-Transistor ist; und
wobei der zweite Transistor (262) ein n-Typ-Transistor ist.

4. Halbleitervorrichtung nach einem der Ansprüche 1 bis 3, wobei das Substrat (200), das das Halbleitermaterial enthält, ein einkristallines Halbleitersubstrat oder ein SOI-Substrat ist.

5. Halbleitervorrichtung nach einem der Ansprüche 1 bis 4, wobei die Oxidhalbleiterschicht (240) ein Oxidhalbleitermaterial auf In-Ga-Zn-O-Basis enthält.

6. Halbleitervorrichtung nach einem der Ansprüche 1 bis 5, wobei die Oxidhalbleiterschicht (240) einen In₂Ga₂ZnO₇-Kristall enthält.

7. Halbleitervorrichtung nach einem der Ansprüche 1 bis 6, wobei eine Wasserstoffkonzentration der Oxidhalbleiterschicht (240) 5 × 10¹⁹ Atome/cm³ oder weniger beträgt.

8. Halbleitervorrichtung nach Anspruch 7,
wobei der zweite Transistor ein n-Typ-Transistor ist, und
wobei ein Sperrstrom des zweiten Transistors (262) aufgrund der Wasserstoffkonzentration der Oxidhalbleiterschicht (240) von 5 × 10¹⁹ Atome/cm³ oder weniger 1 × 10⁻¹³ A oder weniger bei einer Drainspannung Vd von 1 oder 10 V und einer Gatespannung V_{g} von -20 bis -5 V ist.

## Revendications

1. Dispositif semi-conducteur comprenant:
un premier transistor (260) comprenant une région de formation de canal (216) dans un substrat (200) contenant un matériau semi-conducteur, des régions d'impuretés (214) formées avec la région de formation de canal (216) interposée entre elles, une première couche isolante de grille (208a) au-dessus de la région de formation de canal (216), une première électrode de grille (210a) au-dessus de la première couche isolante de grille (208a), et une première électrode de source (230a) et une première électrode de drain (230b) qui sont connectées électriquement aux régions d'impuretés (214);
un second transistor (262) comprenant une seconde électrode de grille (236c) au-dessus du substrat (200) contenant le matériau semi-conducteur, une seconde couche isolante de grille (238) au-dessus de la seconde électrode de grille (236c), une couche d'oxyde semi-conducteur (240) au-dessus de la seconde couche isolante de grille (238), et une seconde électrode de source (242a) et une seconde électrode de drain (242b) qui sont connectées électriquement à la couche d'oxyde semi-conducteur (240);
une première couche isolante (228) interposée entre le premier transistor (260) et le second transistor (262) et une troisième couche isolante (246) au-dessus du second transistor (262);
une couche isolante intercouche (226) au-dessus du premier transistor (260), la première couche isolante (228) étant disposée au-dessus de la couche isolante intercouche (226);
une seconde couche isolante (232) et de premières électrodes noyées (236a-236c) sur et en contact avec la première couche isolante (228) et sous la seconde couche isolante de grille (238), les premières électrodes noyées étant noyées dans la seconde couche isolante (232);
une couche isolante protectrice (244) au-dessus de la couche d'oxyde semi-conducteur (240) et en contact avec une partie de la couche d'oxyde semi-conducteur (240), et
une quatrième couche isolante (252) et de secondes électrodes noyées (254a-254d) noyées dans la quatrième couche isolante (252), la quatrième couche isolante (252) étant sur et en contact avec la troisième couche isolante (246), et les secondes électrodes noyées (254a-254d) étant au-dessus de la troisième couche isolante (246),
dans lequel la première électrode de source (230a) et la première électrode de drain (230b) sont formées chacune à travers un trou respectif dans la couche isolante intercouche (226) et dans la première couche isolante (228),
dans lequel l'une de premières électrodes noyées (236a-236c) constitue la seconde électrode de grille (236c) du second transistor (262),
dans lequel la première couche isolante (228) ou la troisième couche isolante (246) est une couche d'oxyde d'aluminium,
dans lequel la troisième couche isolante (246) est disposée au-dessus de la couche isolante protectrice (244),
dans lequel la première électrode de grille (210a) est connectée électriquement à l'une de la seconde électrode de source (242a) et de la seconde électrode de drain (242b) à travers une électrode (230c) formée à travers un autre trou dans la couche isolante intercouche (226) et dans la première couche isolante (228), à travers une électrode noyée (236b) de premières électrodes noyées (236a-236c), à travers une première électrode (250c) formée à travers un premier trou dans la troisième couche isolante (246) et dans la couche isolante protectrice (244), à travers une électrode noyée (254c) de secondes électrodes noyées (254a-254d), et à travers une seconde électrode (250d) formée à travers un second trou dans la troisième couche isolante (246) et dans la couche isolante protectrice (244), la seconde électrode (250d) étant en contact avec ladite une de la seconde électrode de source (242a) et de la seconde électrode de drain (242b), et
dans lequel le matériau semi-conducteur est le silicium.

2. Dispositif semi-conducteur selon la revendication 1,
dans lequel le dispositif semi-conducteur est une mémoire non volatile.

3. Dispositif semi-conducteur selon l'une quelconque des revendications 1 à 2,
dans lequel le premier transistor (260) est un transistor de type p; et
dans lequel le second transistor (262) est un transistor de type n.

4. Dispositif semi-conducteur selon l'une quelconque des revendications 1 à 3, dans lequel le substrat (200) contenant le matériau semi-conducteur est un substrat semi-conducteur monocristallin ou un substrat SOI.

5. Dispositif semi-conducteur selon l'une quelconque des revendications 1 à 4, dans lequel la couche d'oxyde semi-conducteur (240) contient un matériau d'oxyde semi-conducteur à base de In-Ga-Zn-O.

6. Dispositif semi-conducteur selon l'une quelconque des revendications 1 à 5, dans lequel la couche d'oxyde semi-conducteur (240) contient un cristal In₂Ga₂ZnO₇.

7. Dispositif semi-conducteur selon l'une quelconque des revendications 1 à 6, dans lequel une concentration d'hydrogène de la couche d'oxyde semi-conducteur (240) est 5 × 10¹⁹ atomes/cm³ ou moins.

8. Dispositif semi-conducteur selon la revendication 7, dans lequel le second transistor est un transistor de type n, et pour raison de ladite concentration d'hydrogène de la couche d'oxyde semi-conducteur (240) de 5 × 10¹⁹ atomes/cm³ ou moins, un courant de repos du second transistor (262) est 1 × 10⁻¹³A ou moins à une tension de drain Vd de 1 ou 10 V et à une tension de grille V_{g} allant de -20 à -5 V.
